(19) **Europäisches Patentamt / European Patent Office / Office européen des brevets**

(11) **EP 4 682 960 A1**

(12) # EUROPEAN PATENT APPLICATION
published in accordance with Art. 153(4) EPC

(43) Date of publication:
**21.01.2026 Bulletin 2026/04**

(21) Application number: **24770563.5**

(22) Date of filing: **01.03.2024**

(51) International Patent Classification (IPC):
**H01L 31/12** (2006.01)   **H01L 25/00** (2006.01)

(52) Cooperative Patent Classification (CPC):
**H01L 25/00; H10F 55/00**

(86) International application number:
**PCT/JP2024/007704**

(87) International publication number:
**WO 2024/190452 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.03.2023 JP 2023039857**

(71) Applicant: **Panasonic Intellectual Property Management Co., Ltd.**
**Kadoma-shi, Osaka 571-0057 (JP)**

(72) Inventors:
• **KITAHARA Daisuke**
**Kadoma-shi, Osaka 571-0057 (JP)**

• **KURIAKI Tomonari**
**Kadoma-shi, Osaka 571-0057 (JP)**
• **KAJIMOTO Yoshiyuki**
**Kadoma-shi, Osaka 571-0057 (JP)**
• **TAKA Shinsuke**
**Kadoma-shi, Osaka 571-0057 (JP)**
• **NISHIKAWA Hideo**
**Kadoma-shi, Osaka 571-0057 (JP)**

(74) Representative: **Grünecker Patent- und Rechtsanwälte**
**PartG mbB**
**Leopoldstraße 4**
**80802 München (DE)**

(54) **SEMICONDUCTOR RELAY AND ELECTRIC COMPONENT UNIT COMPRISING SAME**

(57)    A semiconductor relay includes first and second input terminals, a light-emitting device, a light-receiving driver device, first and second output terminals, first and second MOSFETs, and a connecting conductor. The connecting conductor is provided on the rear surface of the light-receiving driver device and connects a first source electrode of the first MOSFET to a second source electrode of the second MOSFET. The connecting conductor includes first to third connecting conductive parts. Each of the first and second connecting conductive parts is disposed between the light-receiving driver device and a corresponding one of the first and second source electrodes.

FIG. 1

EP 4 682 960 A1

## Description

Technical Field

The present disclosure relates to a semiconductor relay and an electric component unit including the semiconductor relay.

Background Art

Semiconductor relays, such as a metal-oxide-semiconductor field effect transistor (MOSFET) output photocoupler and a photo MOSFET are known for transmitting signals. With such semiconductor relays, the increasing insertion loss is problematic along with an increase in transmission signal frequency.

In order to solve this problem, the configuration disclosed in, e.g., PTL 1 has been proposed. In the semiconductor relay disclosed in PTL 1, a light-emitting device placed on an input terminal faces a light-receiving device placed on an output terminal inside a housing. Both the input terminal and the output terminal are bent once, and leading end portions thereof protrude to the outside of the housing along the lower surface of the housing.

This semiconductor relay is placed on a circuit board with a signal wire and a ground wire formed on an upper surface of the circuit board. The light-receiving device and a device placement part of the input terminal on which the light-receiving device is placed may be distanced from the ground wire or a ground plane formed on the lower surface of the circuit board. Both the ground wire and the ground plane are electrically connected to the ground potential. This configuration reduces a capacitance value of a parasitic capacitance between mounting parts of the semiconductor relay and the ground potential, and reduces an insertion loss.

Citation List

Patent Literature

PTL 1: Japanese Patent No. 5491894

Summary of Invention

Recent years have seen an increase in demand for smaller semiconductor relays. Furthermore, there is a demand for an increase in the frequency of signals that are transmitted via the semiconductor relays, and there is accordingly a demand for further improved signal transmission properties in a high-frequency range.

A semiconductor relay according to the present disclosure includes: a first input terminal; a second input terminal; a light-emitting device electrically connected to the first input terminal and the second input terminal; a light-receiving driver device including a light-receiving device that receives light output from the light-emitting device, the light-receiving driver device outputting a drive signal according to the light received; a first output terminal; a second output terminal; a first metal-oxide-semiconductor field effect transistor (MOSFET) including a first drain electrode; a second MOSFET; and a connecting conductor. The first MOSFET includes a first gate electrode configured to have the drive signal input thereto; a first source electrode; and a first drain electrode electrically connected to the first output terminal. The second MOSFET includes: a second gate electrode configured to have the drive signal input thereto; a second source electrode; and a second drain electrode electrically connected to the second output terminal. The connecting conductor is electrically connected to the first source electrode and the second source electrode. The first MOSFET has a first front surface and a first rear surface opposite to the first front surface. The first front surface has the first gate electrode and the first source electrode provided thereon. The second MOSFET has a second front surface and a second rear surface opposite to the second front surface. The second front surface has the second gate electrode and the second source electrode provided thereon. The first front surface of the first MOSFET includes a first placement part and a first non-placement part. The first placement part has the first source electrode provided thereon and has the light-receiving driver device placed thereon. The first non-placement part has the first gate electrode provided thereon and does not have the light-receiving driver device placed thereon. The second front surface of the second MOSFET includes a second placement part and a second non-placement part. The second placement part has the second source electrode provided thereon and has the light-receiving driver device placed thereon. The second non-placement part has the second gate electrode provided thereon and does not have the light-receiving driver device placed thereon. The first MOSFET and the second MOSFET are located in a first direction from the light-receiving driver device so as to face a rear surface of the light-receiving driver device. The first MOSFET is located in a second direction perpendicular to the first direction from the second MOSFET. The connecting conductor includes a first connecting conductive part, a second connecting conductive part, and a third connecting conductive part. The first connecting conductive part overlaps the first MOSFET when viewed in the first direction. The second connecting conductive part overlaps the second MOSFET when viewed in the first direction. The third connecting conductive part electrically connects the first connecting conductive part to the second connecting conductive part. The third connecting conductive part overlaps none of the first MOSFET and the second MOSFET when viewed in the first direction. The connecting conductor is provided on the rear surface of the light-receiving driver device.

An electric component unit according to the present disclosure includes the semiconductor relay and a circuit board having the semiconductor relay mounted thereon. The circuit board includes a dielectric layer, a wiring layer provided on the dielectric layer, and a ground layer provided on the dielectric layer. The wiring layer includes a first wire and a second wire. The first wire is connected to the first input terminal and the second input terminal. The second wire is connected to the first output terminal and the second output terminal.

According to the present disclosure, the semiconductor relay has a small size, and has an insertion loss reduced.

Brief Description of Drawings

FIG. 1 is a perspective view of a semiconductor relay according to Exemplary Embodiment 1.

FIG. 2 is a side view of the semiconductor relay according to Embodiment 1 when viewed in direction A indicated in FIG. 1.

FIG. 3 illustrates a first input terminal and a second input terminal with a light-emitting device placed thereon of the semiconductor relay according to Embodiment 1 when viewed in direction B shown in FIG. 2.

FIG. 4A illustrates a first output terminal and a second output terminal with a light-receiving driver device, a first MOSFET, and a second MOSFET placed thereon of the semiconductor relay according to Embodiment 1 when viewed in direction C shown in FIG. 2.

FIG. 4B illustrates the light-receiving driver device, the first MOSFET, the second MOSFET, the first output terminal, and the second output terminal illustrated in FIG. 4A when viewed from above in the Z-axis direction.

FIG. 4C is a partially exploded perspective view of the light-receiving driver device, the first MOSFET, the second MOSFET, the first output terminal, and the second output terminal illustrated in FIG. 4A.

FIG. 5 is a perspective view of the light-emitting device of the semiconductor relay according to Embodiment 1.

FIG. 6A is a perspective view of the light-receiving driver device of the semiconductor relay according to Embodiment 1.

FIG. 6B is a perspective view of another light-receiving driver device of the semiconductor relay according to Embodiment 1.

FIG. 7 is a perspective view of the first MOSFET of the semiconductor relay according to Embodiment 1.

FIG. 8 is a perspective view of an electric component unit according to Embodiment 1.

FIG. 9 is an equivalent circuit diagram of the semiconductor relay according to Embodiment 1.

FIG. 10A is a diagram illustrating a signal path of the semiconductor relay according to Embodiment 1.

FIG. 10B is another diagram illustrating a signal path of a semiconductor relay according to Embodiment 1.

FIG. 10C is still another diagram illustrating a signal path in a semiconductor relay according to Embodiment 1.

FIG. 11 illustrates a semiconductor relay according to a comparative example corresponding to FIG. 2.

FIG. 12 illustrates a comparison between a signal path of the semiconductor relay according to Embodiment 1 and a signal path of the semiconductor relay according to the comparative example.

FIG. 13 schematically illustrates a distribution of parasitic capacitances of the semiconductor relay according to the comparative example.

FIG. 14 schematically illustrates the effects of reduced capacitive coupling between input and output ends of the semiconductor relay according to Embodiment 1.

FIG. 15 schematically illustrates effects of reduced capacitive coupled to a ground potential of the semiconductor relay according to Embodiment 1.

FIG. 16 is a perspective view of a semiconductor relay according to exemplary Embodiment 2.

FIG. 17 is a side view of the semiconductor relay according to Embodiment 2 when viewed in direction D indicated in FIG. 16.

FIG. 18 illustrates a first input terminal and a second input terminal with a light-emitting device placed thereon of the semiconductor relay according to Embodiment 2 when viewed in direction E indicated in FIG. 17.

FIG. 19 illustrates a first output terminal and a second output terminal with a light-receiving driver device, a first MOSFET, and a second MOSFET placed thereon of the semiconductor relay according to Embodiment 2 when viewed in direction F indicated in FIG. 17.

FIG. 20 schematically illustrates a comparison between an output-end signal path of the semiconductor relay according to Embodiment 1 and an output-end signal path of the semiconductor relay according to Embodiment 2.

FIG. 21 illustrates a positional relationship comparison between a first input terminal, a second input terminal, and a light-emitting device of the semiconductor relay according to Embodiment 1 and a first input terminal, a second input terminal, and a light-emitting device of the semiconductor relay according to Embodiment 2.

FIG. 22 is a diagram of a first output terminal and a second output terminal with a light-receiving driver device, a first MOSFET, and a second MOSFET placed thereon according to Modification 1 corresponding to FIG. 4A.

FIG. 23 is a diagram of a first output terminal and a second output terminal with a light-receiving driver device, a first MOSFET, and a second MOSFET placed thereon according to Modification 2 corresponding to FIG. 4B.
FIG. 24 is a perspective view of a semiconductor relay according to Exemplary Embodiment 3.
FIG. 25 is a perspective view of another semiconductor relay according to Embodiment 3.
FIG. 26 is a perspective view of still another semiconductor relay according to Embodiment 3.
FIG. 27 is a perspective view of another semiconductor relay according to Embodiment 2.
FIG. 28 is a perspective view of a further semiconductor relay according to Embodiment 1.
FIG. 29 is a perspective view of a further semiconductor relay according to Embodiment 3.
FIG. 30 is a perspective view of a further semiconductor relay according to Embodiment 3.
FIG. 31 is a perspective view of a semiconductor relay according to exemplary Embodiment 4.
FIG. 32 is a perspective view of another semiconductor relay according to Embodiment 4.
FIG. 33 is a perspective view of still another semiconductor relay according to Embodiment 4.

Description of Embodiments

Exemplary embodiments of the present disclosure will be described below with reference to drawings. The following description of preferred exemplary embodiments is essentially a mere example and is not intended to limit the present disclosure, the applicable range thereof, or the usage thereof.

Exemplary Embodiment 1

Configuration of Semiconductor Relay

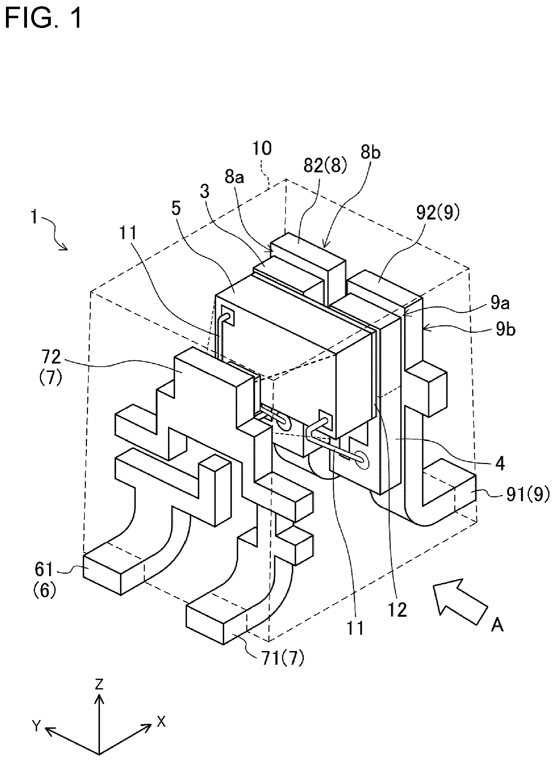

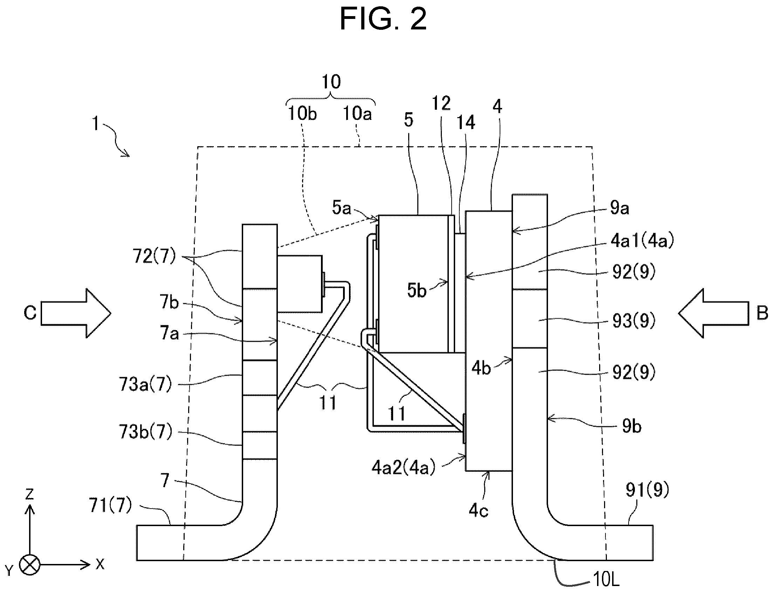

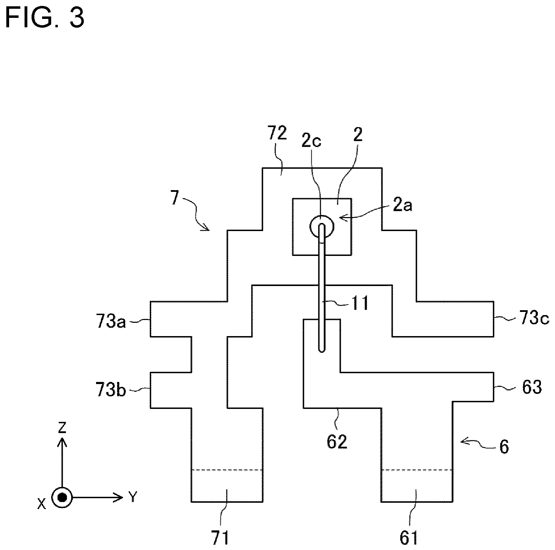

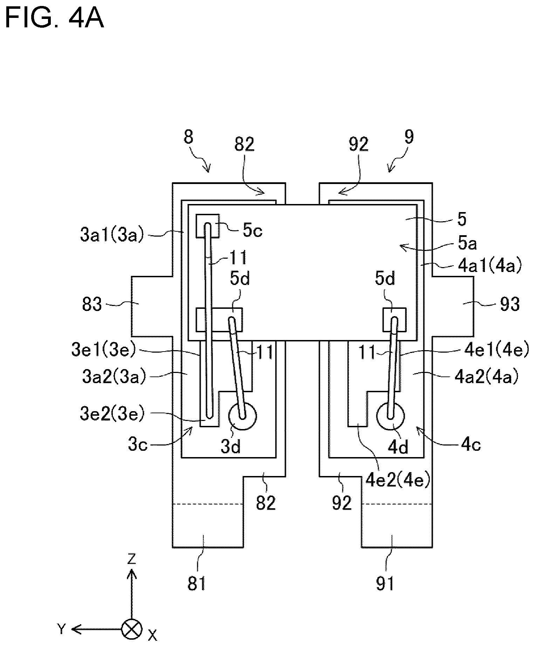

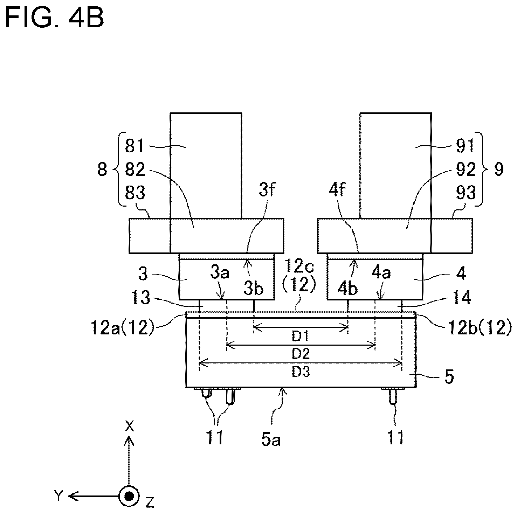

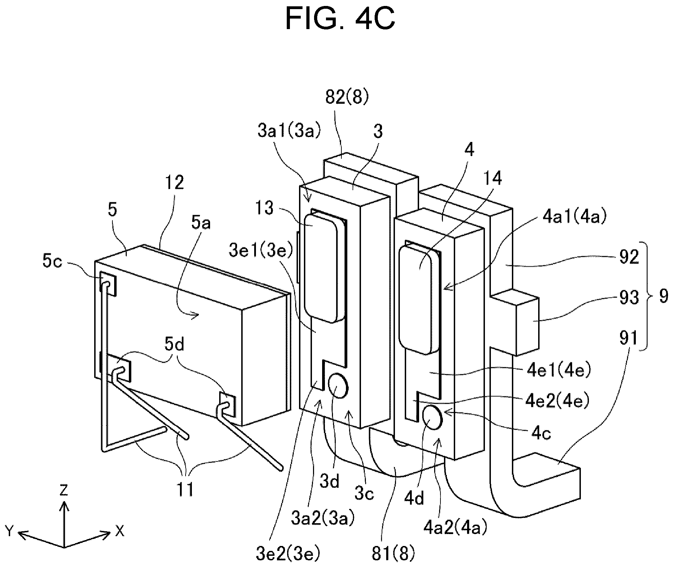

FIG. 1 is a perspective view of a semiconductor relay according to the present exemplary embodiment. FIG. 2 is a side view of the semiconductor relay when viewed in direction A indicated in FIG. 1. FIG. 3 illustrates a first input terminal and a second input terminal with a light-emitting device placed thereon when viewed in direction B indicated in FIG. 2. FIG. 4A illustrates the first output terminal and the second output terminal with a light-receiving driver device, a first metal-oxide-semiconductor field effect transistor (MOSFET), and a second MOSFET placed thereon when viewed in direction C indicated in FIG. 2. FIG. 4B is a diagram of the light-receiving driver device, the first MOSFET, the second MOSFET, the first output terminal, and the second output terminal illustrated in FIG. 4A, as viewed from above in the Z-axis direction. FIG. 4C is a partially exploded perspective view of the light-receiving driver device, the first MOSFET, the second MOSFET, the first output terminal, and the second output terminal illustrated in FIG. 4A.

For convenience of description, the contours of housing 10 and light-blocking resin 10a and light-transmissive resin 10b that constitute housing 10 are illustrated by dashed lines in FIGS. 1 and 2.

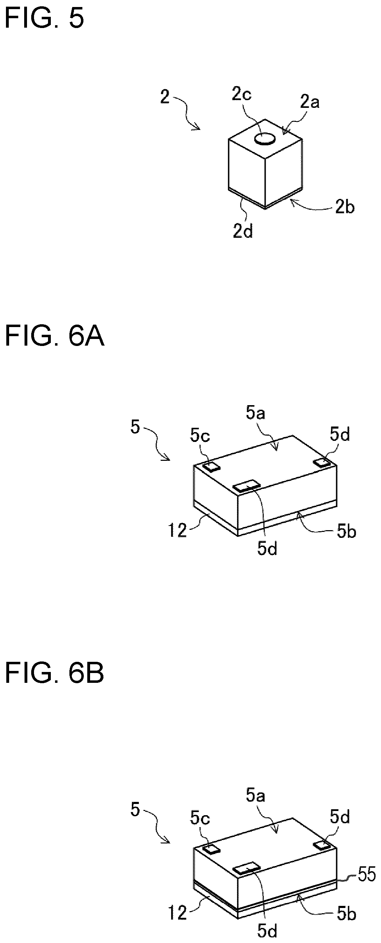

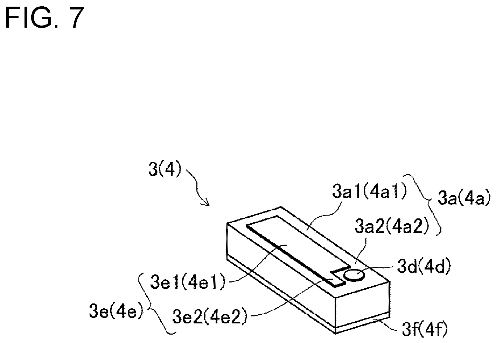

FIG. 5 is a perspective view of the light-emitting device. FIG. 6A is a perspective view of the light-receiving driver device. FIG. 7 is a perspective view of the first MOSFET.

In the following description, a direction in which light-emitting device 2 faces light-receiving driver device 5 may be referred to as an X-axis direction. A direction in which first output terminal 8 and second output terminal 9 are arranged may be referred to as a Y-axis direction. In the Y-axis direction, first input terminal 6 and second input terminal 7 are also arranged. A direction perpendicular to the X-axis direction and the Y-axis direction may be referred to as a Z-axis direction. In accordance with the exemplary embodiments, terms indicating directions, such as "upper surface," "lower surface," "upper/higher," "lower/below," and "up-down direction" indicate relative directions determined only by the relative positional relationship of components, such as the MOSFET and the light-receiving driver device, of the semiconductor relay and do not indicate an absolute directions, such as a vertical direction.

In the specification of the present application, being "perpendicular" or being "parallel" means being perpendicular or being parallel including machining tolerances, manufacturing tolerances, and component-to-component erection tolerances of components included in semiconductor relay 1. The term does not mean that targets to be compared are perpendicular or parallel to each other in a strict sense.

In the present exemplary embodiment, light-receiving driver device 5, first MOSFET 3, and second MOSFET 4 are also arranged in the X-axis direction. In the Z-axis direction, the side on which first MOSFET mount 82 is disposed may be referred to as above or upper, and the side on which first output external terminal part 81 is disposed may be referred to as below or lower. The terms "above" and "below" in the specification of the present application merely represent relative positions and do not mean "above" and "below" in, e.g., the vertical direction.

The terms "front" and "rear" in the present exemplary embodiment are defined as follows. First, the surface of light-emitting device 2 having anode electrode 2c provided thereon is defined as front surface 2a, and the surface of light-emitting device 2 having cathode electrode 2d provided thereon is defined as rear surface 2b. The surface of light-receiving driver device 5 having source electrode 5c and drain electrode 5d provided thereon is defined as front surface 5a. The surface of light-receiving driver device 5 opposite to front surface 5a is defined as rear surface 5b. The surfaces of first MOSFET 3 and second MOSFET 4 having first and second gate electrodes 3d and 4d and first and second source electrodes 3e and 4e are defined as front surfaces 3a and 4a, respectively. The surfaces of first MOSFET 3 and second MOSFET 4 opposite to front surfaces 3a and 4a are defined as rear surfaces 3b and 4b, respectively.

The surfaces of first input terminal 6, second input terminal 7, first output terminal 8, and second output terminal 9 having the devices placed thereon or having wire 11 connected thereto are defined as front surfaces 6a, 7a, 8a, and 9a. The surfaces of first input terminal 6, second input terminal 7, first output terminal 8, and second output terminal 9 opposite to front surfaces 6a, 7a, 8a, and 9a are defined as rear surfaces 6b, 7b, 8b, and 9b, respectively.

As illustrated in FIGS. 1 and 2, semiconductor relay 1 includes light-emitting device 2, light-receiving driver device 5, first MOSFET 3, and second MOSFET 4. Semiconductor relay 1 further includes first input terminal 6, second input terminal 7, first output terminal 8, second output terminal 9, and housing 10.

Light-emitting device 2 is a known light-emitting diode (LED) device. As illustrated in FIG. 5, anode electrode 2c is formed on front surface 2a of the light-emitting device, and cathode electrode 2d is formed on rear surface 2b of the light-emitting device. Cathode electrode 2d is connected and fixed to front surface 7a of light-emitting device mount 72 of second input terminal 7 via an electrically conductive adhesive, such as a silver paste. In other words, cathode electrode 2d is electrically connected to second input terminal 7.

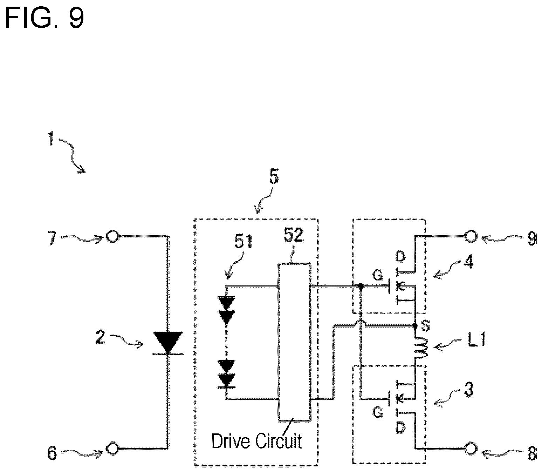

Light-receiving driver device 5 includes light-receiving device 51 and drive circuit 52 (refer to FIG. 9). Light-receiving device 51 includes known photodiodes arranged in, e.g., an array. As illustrated in FIG. 6A, source electrode 5c and drain electrode 5d are formed on front surface 5a of light-receiving driver device 5. Drain electrodes 5d are provided at two separate locations on front surface 5a. Light-receiving device 51 is also formed on front surface 5a of light-receiving driver device 5, but the illustration thereof is omitted for convenience of description.

As illustrated in FIGS. 4B, 4C, and 6A, connecting conductor 12 is formed on rear surface 5b of light-receiving driver device 5. Connecting conductor 12 is formed across entire rear surface 5b of light-receiving driver device 5. Connecting conductor 12 made of one or more electrically conductive films is a laminated or sheet-shaped electrically conductive member. Configuration and functions of connecting conductor 12 will be described later. Connecting conductor 12 per se is made of an electrically conductive adhesive sheet bonded to rear surface 5b of light-receiving driver device 5. Alternatively, connecting conductor 12 may be made of an electrically conductive adhesive sheet bonded to rear surface 5b of light-receiving driver device 5 and an electrically conductive plate bonded to the electrically conductive adhesive sheet.

FIG. 6B is a perspective view of another light-receiving driver device 5 according to Embodiment 1. Light-receiving driver device 5 illustrated in FIG. 6B includes insulating adhesive sheet 55 provided on rear surface 5b thereof. Connecting conductor 12 is provided on rear surface 5b of light-receiving driver device 5 by being bonded to insulating adhesive sheet 55. Insulating adhesive sheet 55 enhances adhesion between light-receiving driver device 5 and connecting conductor 12, enhancing insulation between light-receiving driver device 5 and connecting conductor 12.

As illustrated in FIGS. 4A and 4C, source electrode 5c of light-receiving driver device 5 is electrically connected to first source electrode 3e of first MOSFET 3 via wire 11. One of two drain electrodes 5d and 5d of light-receiving driver device 5 is electrically connected to first gate electrode 3d of first MOSFET 3 via wire 11. The other of two drain electrodes 5d and 5d is electrically connected to second gate electrode 4d of second MOSFET 4 via wire 11.

First MOSFET 3 is obtained by forming a known vertical MOSFET on a semiconductor substrate. First MOSFET 3 includes plural vertical MOSFETs connected in series or in parallel to one another. First MOSFET 3 may be a single vertical MOSFET. As illustrated in FIG. 7, first gate electrode 3d and first source electrode 3e are formed on front surface 3a of first MOSFET 3, and first drain electrode 3f is formed on rear surface 3b of first MOSFET 3. First drain electrode 3f is formed on the entire of rear surface 3b of first MOSFET 3.

A region of first MOSFET 3 in which first gate electrode 3d and first source electrode 3e are formed may be referred to as first cell region 3c. First cell region 3c is a MOSFET functional cell region in which one or more vertical MOSFETs are formed. Specifically, the MOSFET functional cell region is a region in which a gate, a drain, and a source that allow the MOSFET to function as MOSFET and are connected with the gate electrode, the source electrode, and the drain electrode, respectively are formed on a semiconductor chip.

As illustrated in FIG. 7, first source electrode 3e includes first electrode main body 3e1 and first electrode extension 3e2. As illustrated in FIG. 4C, the longitudinal direction of first electrode main body 3e1 inside semiconductor relay 1 is the Z-axis direction. First electrode extension 3e2 continuously extends from first electrode main body 3e1. First electrode main body 3e1 includes a portion that overlaps light-receiving driver device 5 when viewed in the X-axis direction (refer to FIGS. 4A and 4C).

Second MOSFET 4 has substantially the same structure as first MOSFET 3 (refer to FIG. 7). Thus, the arrangement and shapes of second gate electrode 4d, second source electrode 4e, and second drain electrode 4f are substantially the same as those in first MOSFET 3. Specifically, second source electrode 4e includes second electrode main body 4e1 and second electrode extension 4e2, and the shapes and arrangement thereof are the same as the shapes and arrangement of first electrode main body 3e1 and first electrode extension 3e2. For example, second electrode main body 4e1 includes a portion that overlaps light-receiving driver device 5 when viewed in the X-axis direction (refer to FIGS. 4A and 4C).

A region of front surface 4a of second MOSFET 4 in which second gate electrode 4d and second source electrode 4e are formed may be referred to as second cell region 4c. Similar to first cell region 3c, second cell region 4c is a MOSFET functional cell region in which one or more vertical MOSFETs are formed.

As illustrated in FIG. 4C, first connector 13 is provided on the front surface of first electrode main body 3e1 of first source electrode 3e. Second connector 14 is provided on the front surface of second electrode main body 4e1 of second source electrode 4e.

In the following description, front surface 3a of first MOSFET 3 may be referred to as first front surface 3a, and front surface 4a of second MOSFET 4 may be referred to as second front surface 4a.

As illustrated in FIG. 4B and FIG. 4C, light-receiving driver device 5 is placed on first front surface 3a and second front surface 4a via first connector 13 and second connector 14, respectively. Portions of first front surface 3a and second front surface 4a on which light-receiving driver device 5 is placed may be referred to as first placement part 3a1 and second placement part 4a1, respectively. Portions of first front surface 3a and second front surface 4a on which light-receiving driver device 5 is not placed may be referred to as first non-placement part 3a2 and second non-placement part 4a2.

First electrode main body 3e1 of first source electrode 3e is provided on first placement part 3a1, and second electrode main body 4e1 of second source electrode 4e is provided on second placement part 4a1. First electrode extension 3e2 of first source electrode 3e and first gate electrode 3d are provided on first non-placement part 3a2, and second electrode extension 4e2 of second source electrode 4e and second gate electrode 4d are provided on second placement part 4a1.

As illustrated in FIG. 2, first drain electrode 3f of first MOSFET 3 is fixed to front surface 8a of first MOSFET mount 82 of first output terminal 8 with an electrically-conductive adhesive, such as a silver paste. Second drain electrode 4f of second MOSFET 4 is fixed to front surface 9a of second MOSFET mount 92 of second output terminal 9 with an electrically-conductive adhesive.

First connector 13 and second connector 14, which are an electrical conductors, are made of, e.g., solder. The materials and shapes of first connector 13 and second connector 14 are not particularly limited to those described herein; for example, first connector 13 and second connector 14 may be bump electrodes. In this case, first connector 13 is provided by forming plural first connectors 13 on the front surface of first electrode main body 3e1 of first source electrode 3e. Plural second connectors 14 may be formed on the front surface of second electrode main body 4e1 of second source electrode 4e.

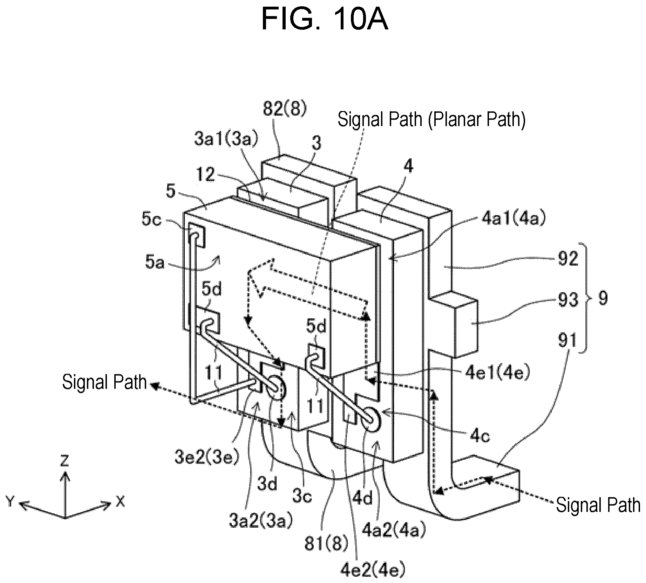

First connector 13 and second connector 14 are electrically connected to connecting conductor 12 formed on rear surface 5b of light-receiving driver device 5 (refer to FIG. 10A to FIG. 10C). First source electrode 3e of first MOSFET 3 is electrically connected to second source electrode 4e of second MOSFET 4 via connecting conductor 12 and first connector 13 and second connector 14.

As illustrated in FIG. 4B, connecting conductor 12 includes first to third connecting conductive parts 12a to 12c. First connecting conductive part 12a is a portion of connecting conductor 12 that is disposed between light-receiving driver device 5 and first electrode main body 3e1 of first source electrode 3e and electrically connected to first connector 13. Second connecting conductive part 12b is a portion of connecting conductor 12 that is disposed between light-receiving driver device 5 and second electrode main body 4e1 of second source electrode 4e and electrically connected to second connector 14. Third connecting conductive part 12c is a portion of connecting conductor 12 that electrically connects first connecting conductive part 12a to second connecting conductive part 12b and overlaps light-receiving driver device 5 when viewed in the X-axis direction.

In accordance with the present exemplary embodiment, connecting conductor 12, which is first to third connecting conductive parts 12a to 12c, is a single conductor having a sheet shape. This is not particularly limited; first to third connecting conductive parts 12a to 12c may have different shapes or thicknesses from one another.

Connecting conductor 12 has a size required to electrically connect first connector 13 to second connector 14. Specifically, the width of connecting conductor 12 in the Y-axis direction is greater than or equal to the distance between first connector 13 and second connector 14 in the Y-axis direction. This distance may be distance D1, distance D2, or distance D3 indicated in FIG. 4B. Distance D1 is the distance between a side surface of first connector 13 and a side surface of second connector 14 that faces and adjoins the side surface of first connector 13. Distance D2 is the distance between the center line of first connector 13 and the center line of second connector 14 in the Y-axis direction. These center lines are virtual lines that pass through the respective centers of first connector 13 and second connector 14 and extend in the Z-axis direction. Distance D3 is the distance, in the Y-axis direction, between the side surface of first connector 13 that is most distant from second connector 14 in the Y-axis direction and the side surface of second connector 14 that is most distant from first connector 13 in the Y-axis direction.

The width of connecting conductor 12 in the Z-axis direction is preferably greater than or equal to the length of each of first connector 13 and second connector 14 in the Z-axis direction. This is not limited; the width of connecting conductor 12 in the Z-axis direction may be less than the length of each of first connector 13 and second connector 14 in the Z-axis direction as long as the connection resistance between connecting conductor 12 and each of first connector 13 and second connector 14 is sufficiently low.

First input terminal 6 and second input terminal 7 are electrical conductors obtained by processing copper plates. The front surface of the copper plate is plated with another metal film, for example, a metal film including nickel. The material of the metal film is not particularly limited to that described herein.

Components, such as light-emitting device 2, first MOSFET 3, first MOSFET 4, and light-receiving driver device 5, are mounted on a lead frame obtained by punching a copper plate. The lead frame and the components are sealed with light-blocking resin 10a. First input terminal 6, second input terminal 7, first output terminal 8, and second output terminal 9 are implemented by portions of the lead frame, thus providing semiconductor relay 1. A gap between light-receiving driver device 5 and light-emitting device 2 is filled with light-transmissive resin 10b.

First input terminal 6 includes first input external terminal part 61, wire connecting part 62, and branch 63. Second input terminal 7 includes second input external terminal part 71, light-emitting device mount 72, and branches 73a to 73c. In semiconductor relay 1, first input terminal 6 and second input terminal 7 are arranged side by side in the Y-axis direction and spaced apart from second input terminal 7.

As illustrated in FIGS. 1 and 2, each of first input terminal 6 and second input terminal 7 extends downward in the Z-axis direction from one end thereof located inside housing 10 and is bent near lower surface 10L of housing 10, and the other end thereof extends in the X-axis direction from the side surface of housing 10 and protrudes to the outside of housing 10. Portions of first input terminal 6 and second input terminal 7 that protrude to the outside of housing 10 are first input external terminal part 61 and second input external terminal part 71.

In first input terminal 6, one end of wire 11 is connected to the front surface of wire connecting part 62, and the other end of wire 11 is connected to anode electrode 2c of light-emitting device 2, as illustrated in FIG. 3. Branch 63 extends from wire connecting part 62 in the Y-axis direction, which is different from the X-axis direction, and protrudes away from second input terminal 7. The leading end of branch 63 is exposed on the side surface of housing 10. Branch 63 is a part of the aforementioned lead frame that remains on first input terminal 6 when semiconductor relay 1 is separated.

As described above, light-emitting device 2 is placed on front surface 7a of light-emitting device mount 72 of second input terminal 7. Similar to branch 63, each of branches 73a to 73c is a part of the aforementioned lead frame that remains on second input terminal 7 when semiconductor relay 1 is separated. The leading end of each of branches 73a to 73c protrudes in the Y-axis direction, which is different from the X-axis direction, and is exposed on the side surface of housing 10. Specifically, the leading end of each of branches 73a and 73b protrudes opposite to input terminal 6. The leading end of branch 73c protrudes opposite to the leading end of each of branches 73a and 73b. Portions of branches 73a to 73c exposed on the side surface of housing 10 may be coated with resins applied thereto and hardened.

First output terminal 8 includes first output external terminal part 81, first MOSFET mount 82, and branch 83. Second output terminal 9 includes second output external terminal part 91, second MOSFET mount 92, and branch 93.

As illustrated in FIG. 2, each of first output terminal 8 and second output terminal 9 extends downward in the Z-axis direction from one end thereof located inside housing 10 and is bent near the lower surface of housing 10, and the other end thereof extends in the Y-axis direction from the side surface of housing 10 and protrudes to the outside of housing 10. A portion of first output terminal 8 that protrudes to the outside of housing 10 is first output external terminal part 81. A portion of second output terminal 9 that protrudes to the outside of housing 10 is second output external terminal part 91.

First MOSFET mount 82 and second MOSFET mount 92 are disposed inside housing 10. First MOSFET 3 is placed on front surface 8a of first MOSFET mount 82, and second MOSFET 4 is placed on front surface 9a of second MOSFET mount 92. First output terminal 8 and second output terminal 9 are arranged side by side in the Y-axis direction and spaced apart from each other.

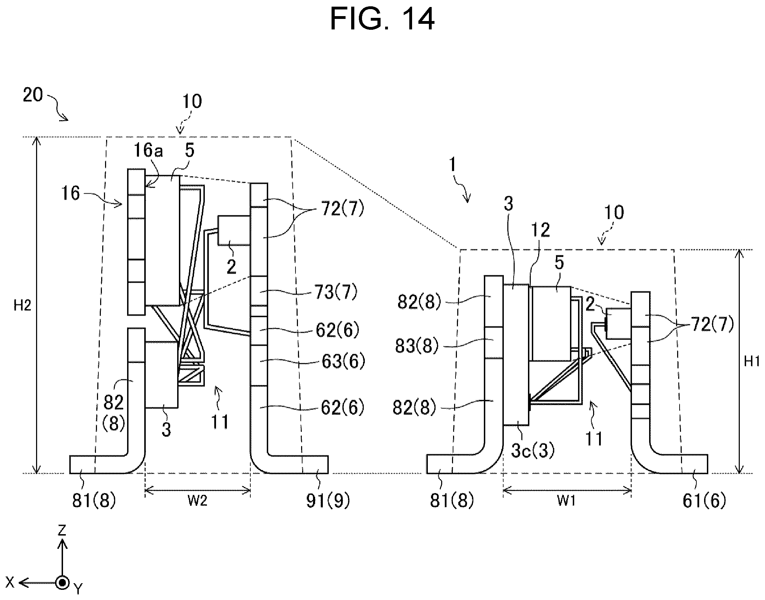

As illustrated in FIG. 2, first MOSFET mount 82 and second MOSFET mount 92 face light-emitting device mount 72 of second input terminal 7 in the X-axis direction with a predetermined distance (= W1 (refer to FIG. 14)) in between. Distance W1 is the distance from front surfaces 8a and 9a of first MOSFET mount 82 and second MOSFET mount 92 to front surface 7a of light-emitting device mount 72 of second input terminal 7 in the X-axis direction.

When viewed in the Z-axis direction, first output external terminal part 81 faces first input external terminal part 61 of first input terminal 6 in the Y-axis direction. Second output external terminal part 91 faces second input external terminal part 71 of second input terminal 7 in the Y-axis direction.

Housing 10 molds first input terminal 6, second input terminal 7, first output terminal 8, and second output terminal 9 and fixes positions thereof. Housing 10 molds light-emitting device 2 placed on second input terminal 7, first MOSFET 3 placed on first output terminal 8, second MOSFET 4 placed on second output terminal 9, and light-receiving driver device 5 and fixes the positions thereof. As mentioned above, first output external terminal part 81, second output external terminal part 91, first input external terminal part 61, and second input external terminal part 71 protrude to the outside of housing 10.

As illustrated in FIG. 2, housing 10 includes light-blocking resin 10a and light-transmissive resin 10b both of which have electrically-insulating properties. Light-blocking resin 10a is made of epoxy resin containing, e.g., black pigment. This is not particularly limited; it is sufficient that a material that blocks light be used. Light-transmissive resin 10b is provided between light-receiving driver device 5 and light-emitting device 2 and sealed with light-blocking resin 10a. Light-transmissive resin 10b is made of, for example, transparent silicone resin. This is not particularly limited; it is sufficient that insulating resin that is transparent to at least light emitted by light-emitting device 2 be used. Light-transmissive resin 10b constitutes an optical coupling part that optically couples light-receiving device 51 of light-receiving driver device 5 with light-emitting device 2.

First input terminal 6, second input terminal 7, first output terminal 8, and second output terminal 9 are electrically insulated from one another with housing 10. Light-emitting device 2 is optically coupled with light-receiving driver device 5. In other words, semiconductor relay 1 is an input/output insulated semiconductor relay configured to turn on and off an output signal by optical coupling while input and output signals are electrically insulated from each other.

Configuration of Electric Component Unit

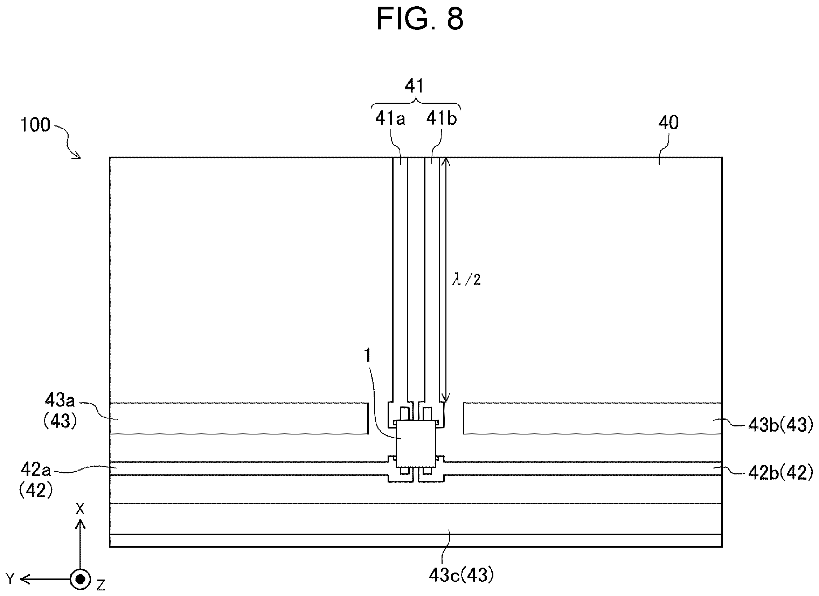

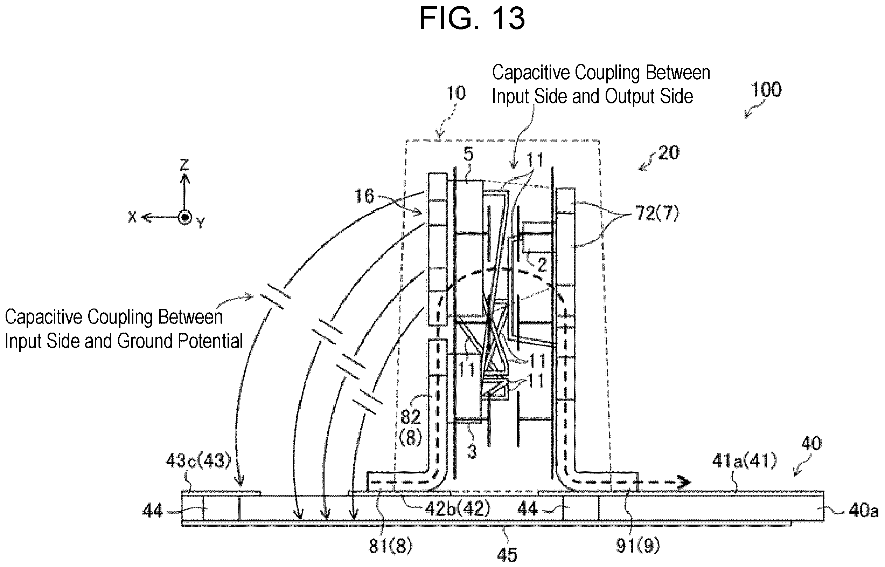

FIG. 8 is a perspective view of an electric component unit according to the exemplary embodiment. Electric component unit 100 includes semiconductor relay 1 and circuit board 40. Circuit board 40 is a so-called a printed wiring board obtained by forming first to third wires 41, 42, and 43 on a front surface of dielectric substrate 40a made of dielectric material having predetermined dielectric constant. Ground plane 45 (for example, refer to FIG. 13) is formed on a lower surface of dielectric substrate 40a. Ground plane 45 is formed on an entire rear surface of dielectric substrate 40a. First to third wires 41, 42, and 43 and ground plane 45 are formed by, e.g., plating the front or rear surface of dielectric substrate 40a with copper.

Third wire 43 is electrically connected to ground plane 45 with conductive via 44 (for example, refer to FIG. 14) passing through dielectric substrate 40a in the thickness direction, in this case, in the Z-axis direction. Ground plane 45 is electrically connected to the ground potential of electric component unit 100. In order to reduce the transmission loss of transmission signals, dielectric substrate 40a has a small dielectric constant.

First wire 41 includes a pair of wires 41a and 41b extending in the X-axis direction parallel to each other with a space in between in the Y-axis direction. First wire 41 is an input signal wire through which an input signal is input to semiconductor relay 1. One end of each of the pair of wires 41a and 41b constituting first wire 41 is connected to a corresponding one of first input external terminal part 61 of first input terminal 6 and second input external terminal part 71 of second input terminal 7. Specifically, first input external terminal part 61 and second input external terminal part 71 are connected to the first wire such that the lower surfaces of first input external terminal part 61 and second input external terminal part 71 contact the respective surfaces of the pair of wires 41a and 41b of first wire 41. The other end of each of the pair of wires 41a and 41b constituting first wire 41 is an open end, as illustrated in FIG. 8.

Second wire 42 includes a pair of wires 42a and 42b extending in the Y-axis direction with a space in between in the Y-axis direction. Second wire 42 is an output signal wire for output signals that are output from semiconductor relay 1. One end of each of the pair of wires 42a and 42b constituting second wire 42 is connected to a corresponding one of first output external terminal part 81 of first output terminal 8 and second output external terminal part 91 of second output terminal 9. Specifically, first output external terminal part 81 and second output external terminal part 91 are connected to second wire 42 such that the lower surfaces of first output external terminal part 81 and second output external terminal part 91 contact the respective surfaces of the pair of wires 42a and 42b constituting second wire 42. Second wire 42 is designed as a transmission line with impedance set to 50 $\Omega$ through impedance matching. Second wire 42 may be a pair of wires 42a and 42b elongated in the X-axis direction as the longitudinal direction thereof.

Third wire 43 includes two wires 43a and 43b and wire 43c. Two wires 43a and 43b provided across ends of the pair of wires 41a and 41b constituting first wire 41. Wire 43c is provided opposite to two wires 43a and 43b in the X-axis direction with respect to second wire 42. The longitudinal direction of each of three wires 43a, 43b, 43c is the Y-axis direction. As mentioned above, three wires 43a, 43b, and 43c constituting third wire 43 are electrically connected to the ground potential via ground plane 45. That is, third wire 43 is spaced apart from second wire 42, which is an output signal wire, and surrounds second wire 42 so as to shield radiation noise entering second wire 42.

Although FIG. 8 shows an example where only semiconductor relay 1 is mounted on circuit board 40, other devices may be mounted on circuit board 40.

Operation of Semiconductor Relay

FIG. 9 illustrates an equivalent circuit diagram of the semiconductor relay. Inductor L1 illustrated in FIG. 9 is a parasitic inductance between the source (S) of first MOSFET 3 and the source (S) of second MOSFET 4 and is not an actual structural component of semiconductor relay 1.

When an input signal is input across first input terminal 6 and second input terminal 7, light-emitting device 2 outputs light with a predetermined wavelength. The light generated by light-emitting device 2 propagates through light-transmissive resin 10b and is received by light-receiving device 51.

Light-receiving device 51 generates an electric current by photoelectric conversion, and drive circuit 52 operates according to the electric current. A drive signal that is a voltage signal corresponding to the amount of light from light-emitting device 2 is applied to first gate electrode 3d of first MOSFET 3 and second gate electrode 4d of second MOSFET 4 via wire 11.

When the voltage of the drive signal exceeds the respective threshold voltages of first MOSFET 3 and second MOSFET 4, the channel between the source (S) and the drain (D) of first MOSFET 3 and the channel between the source (S) and the drain (D) of second MOSFET 4 are placed are turned on. Furthermore, first output terminal 8 and second output terminal 9 are connected to each other via first MOSFET 3 and second MOSFET 4. As a result, a signal is transmitted between first output terminal 8 and second output terminal 9 and further transmitted to second wire 42.

When the input signal is no longer input across first input terminal 6 and second input terminal 7, the light emission from light-emitting device 2 stops. Accordingly, light-receiving device 51 no longer generates the electric current, and drive circuit 52 stops.

This configuration decreases the voltage of the drive signal applied to first gate electrode 3d of first MOSFET 3 and second gate electrode 4d of second MOSFET 4. When the voltage of the drive signal exceeds the aforementioned threshold voltages, the channel between the source (S) and the drain (D) of first MOSFET 3 and the channel between the source (S) and the drain (D) of second MOSFET 4 are turned off. Furthermore, first output terminal 8 and second output terminal 9 are disconnected from each other. As a result, the signal transmission between first output terminal and second output terminal 9 is interrupted.

Advantageous Effects

As described above, semiconductor relay 1 according to the present exemplary embodiment is mounted on circuit board 40.

Semiconductor relay 1 includes at least light-emitting device 2, first MOSFET 3, second MOSFET 4, light-receiving driver device 5, first input terminal 6, second input terminal 7, first output terminal 8, second output terminal 9, housing 10, and connecting conductor 12.

Light-emitting device 2 is electrically connected to first input terminal 6 and second input terminal 7.

Light-receiving driver device 5 including light-receiving device 51 configured to receive the light output from light-emitting device 2 outputs the drive signal.

First output terminal 8 includes first MOSFET mount 82, and second output terminal 9 includes second MOSFET mount 82.

First MOSFET 3 includes first gate electrode 3d, first source electrode 3e, and first drain electrode 3f. First source electrode 3e is electrically connected to light-receiving driver device 5, and first drain electrode 3f is electrically connected to first output terminal 8.

Second MOSFET 4 includes second gate electrode 4d, second source electrode 4e, and second drain electrode 4f. Second source electrode 4e is electrically connected to light-receiving driver device 5, and second drain electrode 4f is electrically connected to second output terminal 9.

Connecting conductor 12 is electrically connected to first source electrode 3e and second source electrode 4e.

First MOSFET 3 has first front surface 3a and first rear surface 3b opposite to first front surface 3a. First rear surface 3b is placed on first MOSFET mount 82.

First front surface 3a includes first placement part 3a1 and first non-placement part 3a2. First source electrode 3e is formed on first placement part 3a1, and light-receiving driver device 5 is placed on first placement part 3a1. First gate electrode 3d is formed on first non-placement part 3a2, but light-receiving driver device 5 is not placed on first non-placement part 3a2.

Second MOSFET 4 has second front surface 4a and second rear surface 4b opposite to second front surface 4a. Second rear surface 4b is placed on second MOSFET mount 92.

Second front surface 4a includes second placement part 4a1 and second non-placement part 4a2. Second source electrode 4e is formed on second placement part 4a1, and light-receiving driver device 5 is placed on second placement part 4a1. Second gate electrode 4d is formed on second non-placement part 4a2, but light-receiving driver device 5 is not placed on second non-placement part 4a2.

The direction in which light-receiving driver device 5, first MOSFET 3, and second MOSFET 4 are arranged is defined as the X-axis direction. The direction in which first output terminal 8 and second output terminal 9 are arranged is defined as the Y-axis direction. The direction perpendicular to the X-axis direction and the Y-axis direction is defined as the Z-axis direction.

Connecting conductor 12 includes first connecting conductive part 12a, second connecting conductive part 12b, and third connecting conductive part 12c. First connecting conductive part 12a is disposed between light-receiving driver device 5 and first source electrode 3e. Second connecting conductive part 12b is disposed between light-receiving driver device 5 and second source electrode 4e. Third connecting conductive part 12c includes a portion that electrically connects first connecting conductive part 12a to second connecting conductive part 12b and overlaps the light-receiving driver device when viewed in the X-axis direction.

Connecting conductor 12 is a laminated electrically conductive sheet formed on rear surface 5b of light-receiving driver device 5.

Semiconductor relay 1 having the configuration described above reduces the output-end parasitic inductance components and the insertion loss. This will be further described in comparison to the conventional configuration disclosed in PTL 1.

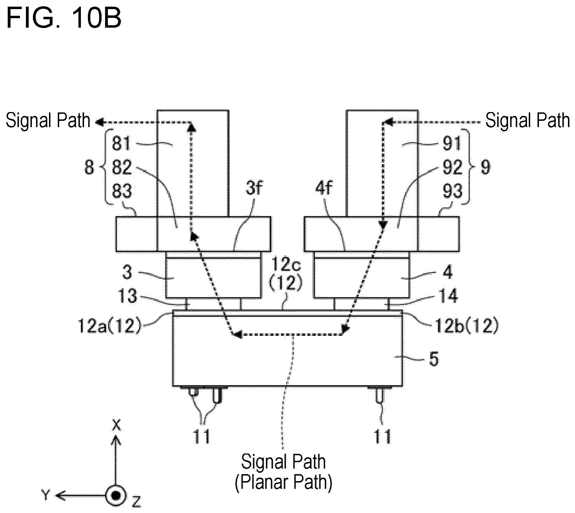

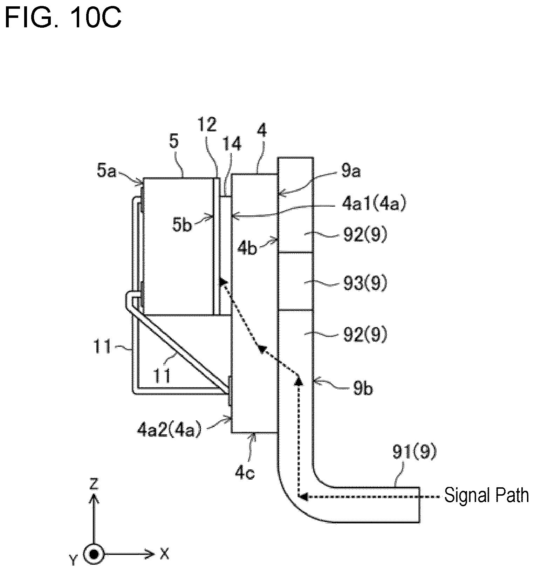

FIG. 10A a diagram illustrating a signal path in the semiconductor relay. FIG. 10B is another diagram illustrating a signal path in the semiconductor relay. FIG. 10C is still another diagram illustrating a signal path in the semiconductor relay.

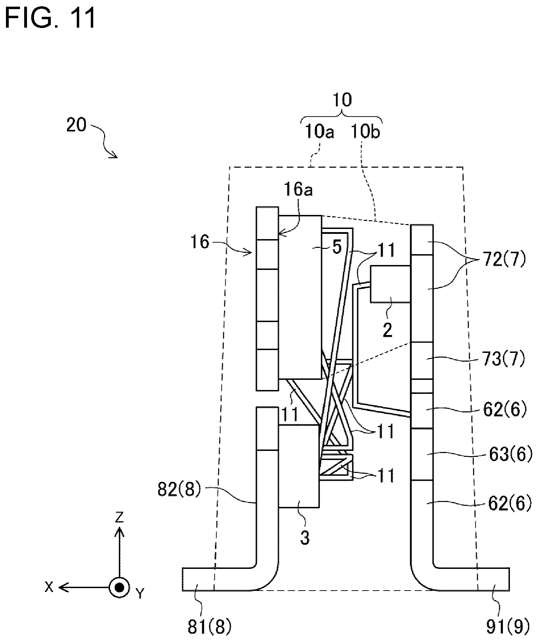

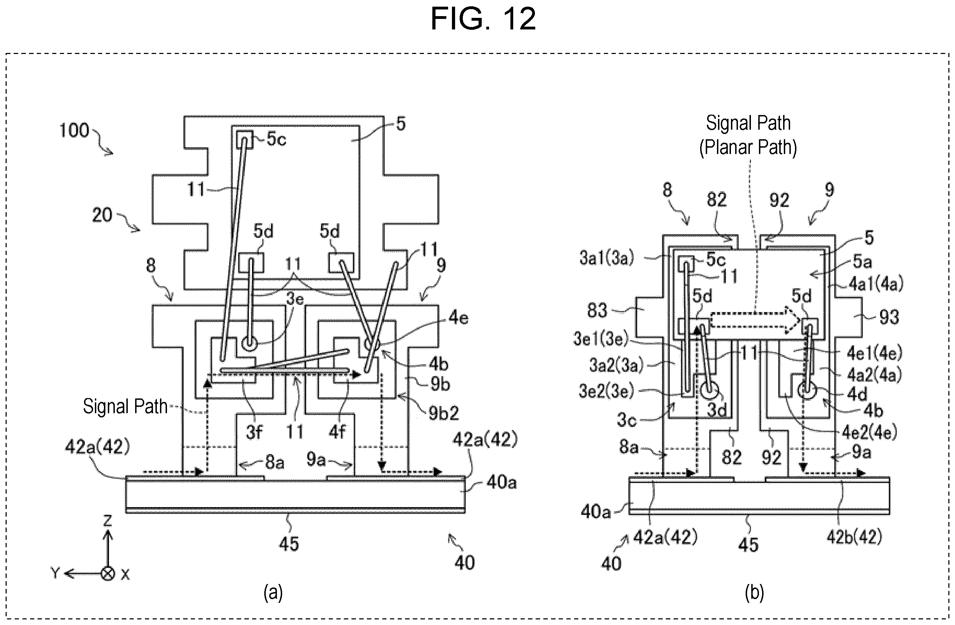

FIG. 11 is a diagram of a semiconductor relay according to a comparative example corresponding to FIG. 2. FIG. 12 is a diagram of comparison between the signal path in the semiconductor relay according to Embodiment 1 and the signal path in the semiconductor relay according to the comparative example. FIG. 13 schematically illustrates a distribution of parasitic capacitance in the semiconductor relay according to the comparative example. FIGS. 10A-10C and 12 illustrate relays where a signal is transmitted from second output terminal 9 to first output terminal 8. In FIGS. 11-13, 14, and 15 described below, elements substantially the same as those illustrated in FIGS. 1-8 are denoted by the same reference numerals and detailed description thereof may be omitted.

As illustrated in FIGS. 10A to 10C, in the signal path for signals that are transmitted from second output terminal 9 to first output terminal 8, the signal path from second source electrode 4e of second MOSFET 4 to first source electrode 3e of first MOSFET 3 includes connecting conductor 12.

As mentioned above, connecting conductor 12 is a laminated electrically conductive sheet formed on entire rear surface 5b of light-receiving driver device 5. This means that the peripheral edge of connecting conductor 12 substantially overlaps the peripheral edge of rear surface 5b of light-receiving driver device 5. Therefore, the signal is transmitted in a planar, spread pattern in connecting conductor 12 (the planar path shown in FIGS. 10A and 10B).

In contrast, conventional semiconductor relay 20 illustrated in FIG. 11 is different from semiconductor relay 1 according to the present embodiment in the following respects. Third device mount 16 is provided above and spaced apart from first output terminal 8 and second output terminal 9 in the Z-axis direction. Light-receiving driver device 5 is placed on front surface 16a of third device mount 16. That is, light-receiving driver device 5 is positioned above and spaced apart from first MOSFET 3 and second MOSFET 4 in the Z-axis direction.

Second source electrode 4e of second MOSFET 4 is connected to first source electrode 3e of first MOSFET 3 with two wires 11. Two wires 11 function as a signal path.

Next, the output-end parasitic inductance components in semiconductor relay 1 according to the present exemplary embodiment and conventional semiconductor relay 20 will be discussed. In both semiconductor relay 1 and semiconductor relay 20, the inductance component along the signal path between second source electrode 4e of second MOSFET 4 and first source electrode 3e of first MOSFET 3 corresponds to L1 described above.

The inductance of wire 11 per unit length along the signal path is roughly proportional to the logarithm of the reciprocal of the wire diameter. Meanwhile, assuming that connecting conductor 12 is a planar conductor, the width of connecting conductor 12 in the Z-axis direction (the width of connecting conductor 12 in a direction crossing the signal path) is greater than the width of connecting conductor 12 in the X-axis direction (the thickness of the planar conductor). In the example illustrated in FIGS. 1-5, the inductance of connecting conductor 12 per unit length along the signal path is less affected by the width of connecting conductor 12 in the X-axis direction (the thickness of the planar conductor) in this case and mainly includes a component proportional to the logarithm of the reciprocal of the width of connecting conductor 12 in the Z-axis direction. Since the width of connecting conductor 12 in the Z-axis direction is a few times or several tens of times greater than the wire diameter of wire 11, semiconductor relay 1 according to the present embodiment including connecting conductor 12 has a smaller inductance per unit length along the signal path than conventional semiconductor relay 20 including wire 11.

In other words, semiconductor relay 1 according to the present embodiment has smaller parasitic inductance components than conventional semiconductor relay 20, and, as a result, semiconductor relay 1 according to the present exemplary embodiment provides a smaller insertion loss than conventional semiconductor relay 20. Furthermore, as a result of a reduction in the inductance along the signal path, the characteristic impedance mismatch of the signal path can be reduced. Accordingly, the reflective properties in the signal path can improve and furthermore, the insertion loss can be reduced.

According to the present embodiment, the capacitive coupling to the ground potential is reduced, and thus, the impact of resonance due to a stub can be reduced. This will be described below.

In both conventional semiconductor relay 20 and semiconductor relay 1 according to the present embodiment, wire 11 that connects source electrode 5c of light-receiving driver device 5 to first source electrode 3e of first MOSFET 3 acts as a stub in a high-frequency circuit.

Suppose that the value of parasitic capacitance between the ground potential and the sources (S) of first MOSFET 3 and second MOSFET 4 is denoted by C and the value of inductance of wire 11 acting as a stub is denoted by L, resonant frequency fc of a resonant circuit including parasitic capacitor and wire 11 satisfies the relationship indicated in Equation (1).

$$\text{fc} = (1/2\pi) \times (LC)^{-1/2} \ \dots \ (1)$$

As illustrated in the figure on the left side in FIG. 12, second source electrode 4e of second MOSFET 4 is connected to third device mount 16 with wire 11 in conventional semiconductor relay 20. As a result, light-receiving driver device 5 is electrically connected to second MOSFET 4 via third device mount 16. Wire 11 acts as a stub. The value of parasitic capacitance between third device mount 16 and the ground potential is added to aforementioned value C of parasitic capacitance in conventional semiconductor relay 20.

As illustrated in the figure on the left side in FIG. 12, light-receiving driver device 5 is positioned above and spaced apart from first MOSFET 3 and second MOSFET 4 in the Z-axis direction in conventional semiconductor relay 20. Therefore, the length of wire 11 that connects source electrode 5c of light-receiving driver device 5 to first source electrode 3e of first MOSFET 3 is greater than the length of wire 11 in semiconductor relay 1 according to the present embodiment illustrated in the figure on the right side in FIG. 12. Thus, conventional semiconductor relay 20 has a larger value L of inductance than semiconductor relay 1 according to the present embodiment.

That is, conventional semiconductor relay 20 has a lower resonant frequency fc indicated in Equation (1) than semiconductor relay 1 according to the present embodiment.

Therefore, conventional semiconductor relay 20 has the impact of resonance due to a stub appearing on the lower frequency side than semiconductor relay 1 according to the present embodiment. In contrast, in semiconductor relay 1 according to the present exemplary embodiment, the frequency characteristics of the insertion loss are generally on the higher frequency side than said frequency characteristics in conventional semiconductor relay 20, meaning that signal attenuation on the higher frequency side is reduced. In other words, regarding the insertion loss, semiconductor relay 1 according to the present embodiment has better high-frequency characteristics than conventional semiconductor relay 20.

In conventional semiconductor relay 20, the positional relationship of light-receiving driver device 5, first MOSFET 3, and second MOSFET 4 is as shown in FIGS. 11 and 12.

As a result, a parasitic capacitance is generated between the ground potential and third device mount 16 due to a capacitive coupling in conventional semiconductor relay 20, as illustrated in FIG. 13. Furthermore, a parasitic capacitance induced by capacitive coupling is generated between each of terminals located at the output end and each of first input terminal 6 and second input terminal 7. The terminals located at the output end are first output terminal 8, second output terminal 9, and third device mount 16. These parasitic capacitances cause the insertion loss when a signal is transmitted between first output terminal 8 and second output terminal 9. As the frequency of the signal increases, the rate of increase in the insertion loss increases.

In contrast, in semiconductor relay 1 according to the present embodiment, third device mount 16 illustrated in FIGS. 11 and 12 is omitted, and light-receiving driver device 5 is placed over first placement part 3a1 of first MOSFET 3 and second placement part 4a1 of second MOSFET 4, as illustrated in FIGS. 1 and 2. As a result, both the capacitive coupling to the ground potential and the capacitive coupling between the input end and the output end are reduced.

The capacitive coupling between a region serving as a stub and the ground potential is reduced and therefore, the insertion loss is reduced.

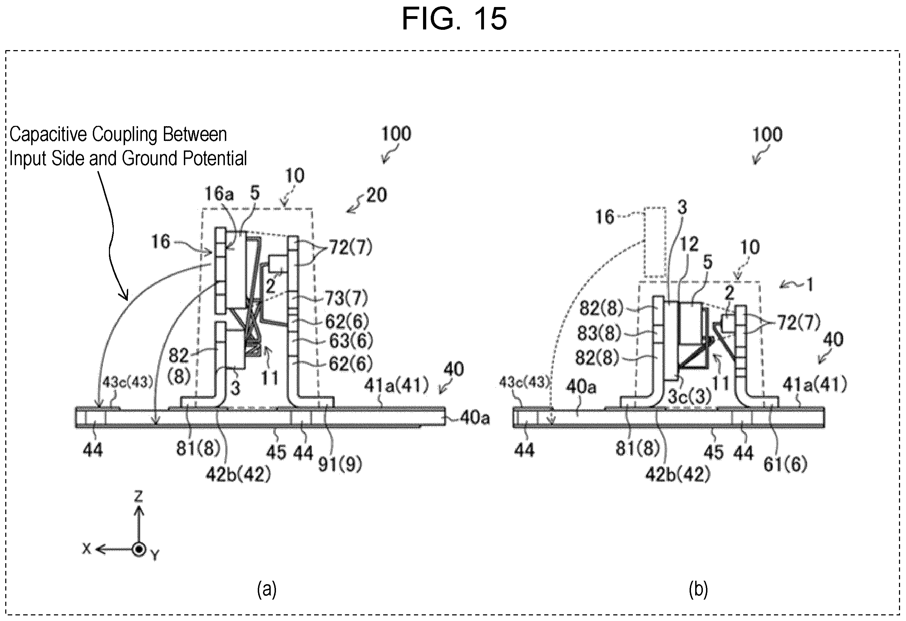

FIG. 14 is a schematic diagram of the relay for describing the effects of reduced capacitive coupling between the input end and the output end. FIG. 15 is a schematic diagram 0f the relay for describing the effects of reduced capacitive coupling to the ground potential.

By omitting third device mount 16, height H1 of semiconductor relay 1 according to the present embodiment in the Z-axis direction is smaller than height H2 of conventional semiconductor relay 20 in the Z-axis direction, as illustrated in FIG. 14. That is, small semiconductor relay 1 with a allow profile is thus provided.

Conventional semiconductor relay 20 may have a small size by reducing the size of first MOSFET 3 and second MOSFET 4. For example, conventional semiconductor relay 20 may have a low profile by reducing the size of first MOSFET 3 and second MOSFET 4 in the Z-axis direction.

However, first MOSFET 3, second MOSFET 4 having s small size have a large ON resistance upon being turned on. Particularly, in a vertical MOSFET, the drain resistance significantly contributes to the ON resistance. First MOSFET 3 and second MOSFET 4 having small areas reduce the drain area, and increases the ON resistance. As a result, the high-frequency characteristics of signals transmitted in semiconductor relay 20 may deteriorate.

In contrast, in semiconductor relay 1 according to the present exemplary embodiment, light-receiving driver device 5 is placed across first placement part 3a1 of first MOSFET 3 and second placement part 4a1 of second MOSFET 4. Thus, semiconductor relay 1 has a small height while first MOSFET 3 and second MOSFET 4 have a certain size. In particular, since the drain area of each of first MOSFET 3 and second MOSFET 4 is not significantly reduced, the increase in the ON resistance can be minimized, and the deterioration of the high-frequency characteristics of signals transmitted in semiconductor relay 1 can be reduced.

Furthermore, by omitting third device mount 16, the output-end electrode area which contributes to the parasitic capacitance is significantly reduced. That is, the capacitive coupling between the input end and the output end is reduced, and the insertion loss is reduced. Distance W1 greater than distance W2 as illustrated in FIG. 14 reduces the capacitive coupling between the input end and the output end, and reduces the insertion loss. Distance W2 is the distance from front surfaces 8a, 9a, and 16a of first MOSFET mount 82, second MOSFET mount 92, and third device mount 16 to front surface 7a of light-emitting device mount 72 of second input terminal 7 in the X-axis direction.

As illustrated in FIG. 15, the parasitic capacitance generated between third device mount 16 and the ground potential no longer exists, and the insertion loss attributable to this parasitic capacitance is reduced.

Semiconductor relay 1 further includes a connector that connects connecting conductor 12 to each of first source electrode 3e of first MOSFET 3 and second source electrode 4e of second MOSFET 4.

The connector includes first connector 13 and second connector 14. First connector 13 is an electrical conductor formed on the front surface of first source electrode 3e, and second connector 14 is an electrical conductor formed on the front surface of second source electrode 4e.

Thus, first connector 13 and second connector 14 allow connecting conductor 12 and each of first source electrode 3e to be reliably connected to second source electrode 4e.

In mounting of light-receiving driver device 5 on first front surface 3a of first MOSFET 3 and second front surface 4a of second MOSFET 4, first connector 13 and second connector 14 serve as a buffer, and relieve the pressure that first MOSFET 3 and second MOSFET 4 receive during mounting.

Upon having a pressure greater than or equal to a predetermined level applied to first MOSFET 3 and second MOSFET 4, the properties of the MOSFETs included therein may change and, in extreme cases, first MOSFET 3 and second MOSFET 4 may be damaged.

In contrast, in accordance with the present embodiment, first connector 13 and second connector 14 avoid the aforementioned troubles, stabilizing the properties of first MOSFET 3 and second MOSFET 4. This configuration increases the manufacturing yield of semiconductor relay 1 by reducing failures in the assembly process.

Connecting conductor 12 may be preferably formed across entire rear surface 5b of light-receiving driver device 5.

This configuration maximizes the width of connecting conductor 12 in the Z-axis direction in the signal path. As a result, the parasitic inductance components is reduced to reduce the insertion loss. Since the characteristic impedance mismatch of the signal path is reduced, the reflective properties in the signal path is improved, and the insertion loss is reduced.

In terms of a reduction in the impedance along the signal path, the width of connecting conductor 12 in the Z-axis direction is preferably greater than or equal to the length of each of first connector 13 and second connector 14 in the Z-axis direction.

The width of connecting conductor 12 in the Y-axis direction is greater than or equal to the distance between first connector 13 and second connector 14 in the Y-axis direction. This configuration reliably electrically connects connecting conductor 12 to each of first connector 13 and second connector 14.

First front surface 3a of first MOSFET 3 includes first cell region 3c in which a functional cell as a MOSFET is formed, and second front surface 4a of second MOSFET 4 includes second cell region 4c in which a functional cell as a MOSFET is formed.

Inside semiconductor relay 1, first connecting conductive part 12a of connecting conductor 12 is spaced apart from first cell region 3c in the Z-axis direction, in other words, in the longitudinal direction of first MOSFET 3. Second connecting conductive part 12b of connecting conductor 12 is spaced apart from second cell region 4c in the Z-axis direction, in other words, in the longitudinal direction of second MOSFET 4.

As a result, regions in which first cell region 3c of first MOSFET 3 and second cell region 4c of second MOSFET 4 are not formed, namely, functional cell absent regions, are connected and fixed to connecting conductor 12 via first connector 13, second connector 14, and the like. This configuration avoids troubles, such as a change in the properties of the MOSFETs included in first cell region 3c and second cell region 4c in mounting of light-receiving driver device 5 on first front surface 3a of first MOSFET 3 and second front surface 4a of second MOSFET 4.

In first MOSFET 3, first placement part 3a1 and first gate electrode 3d are arranged side by side in the Z-axis direction. In second MOSFET 4, second placement part 4a1 and second gate electrode 4d are arranged side by side in the Z-axis direction.

Light-emitting device 2 faces light-receiving driver device 5 in the X-axis direction with a predetermined distance in between. Light-receiving driver device 5 is disposed between light-emitting device 2 and first MOSFET 3 and between light-emitting device 2 and second MOSFET 4.

Semiconductor relay 1 as described above with the above configuration has a size prevented from increasing in the Z-axis direction, thus providing semiconductor relay 1 with a small height and size.

First input terminal 6 includes first input external terminal part 61 exposed from housing 10 to the outside thereof along the lower surface of housing 10. Second input terminal 7 includes second input external terminal part 71 exposed from housing 10 to the outside thereof along the lower surface of housing 10.

First output terminal 8 includes first output external terminal part 81 exposed from housing 10 to the outside thereof along the lower surface of housing 10. Second output terminal 9 includes second output external terminal part 91 exposed from housing 10 to the outside thereof along the lower surface of housing 10.

This configuration provides surface-mount semiconductor relay 1 in which the lower surface of housing 10 is used as a mounting surface.

Electric component unit 100 according to the present embodiment includes at least semiconductor relay 1 and circuit board 40. Circuit board 40 is formed by forming first wire 41 and second wire 42 (wiring layer) and third wire (ground layer) 43 on a front surface of dielectric substrate (dielectric layer) 40a and forming ground plane (ground layer) 45 on the rear surface of dielectric substrate (dielectric layer) 40a.

First wire 41 is connected to each of first input terminal 6 and second input terminal 7 of semiconductor relay 1. Second wire 42 is connected to each of first output terminal 8 and second output terminal 9 of semiconductor relay 1.

First wire 41 is a wire for input of signals to semiconductor relay 1, and second wire 42 is a wire (signal wire) for output of signals from semiconductor relay 1.

Electric component unit 100 according to the present embodiment provides passage and interruption of signals output from semiconductor relay 1 with a simple configuration.

Third wire 43 is further formed on the upper surface of circuit board 40, spaced apart from second wire 42, and surrounds second wire 42. Third wire 43 is electrically connected to ground plane 45 formed on the lower surface of circuit board 40. Ground plane 45 is electrically connected to the ground potential.

Twire 43 connected to the ground potential to surround second wire 42 reduces the occurrence of radiation noise mixed with transmission signals that propagate through second wire 42. This configuration reduces the occurrence of radiation noise propagating from second wire 42 to another electronic component mounted on circuit board 40. Moreover, this configuration easily configures a signal transmission circuit that transmits high-frequency signals that are allowed to pass or are interrupted by semiconductor relay 1.

Exemplary Embodiment 2

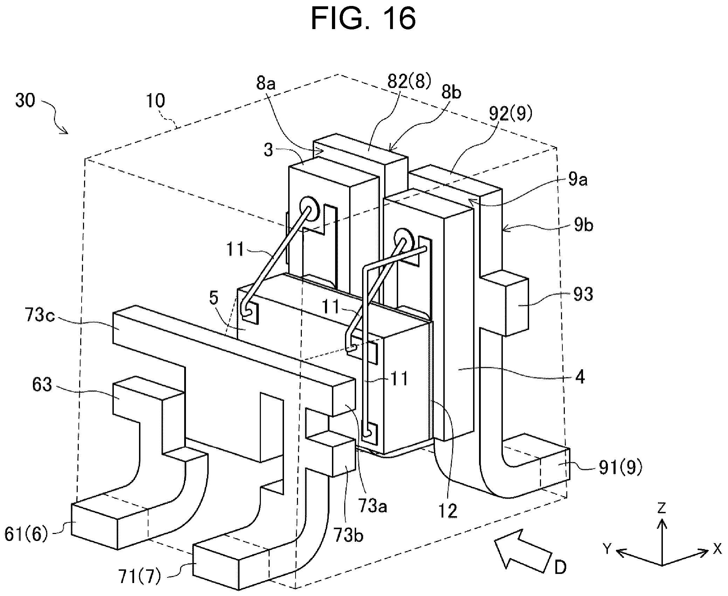

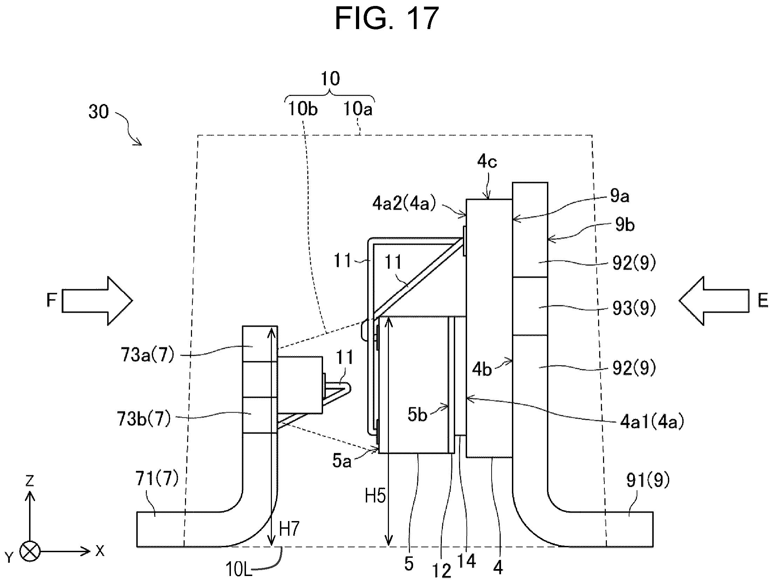

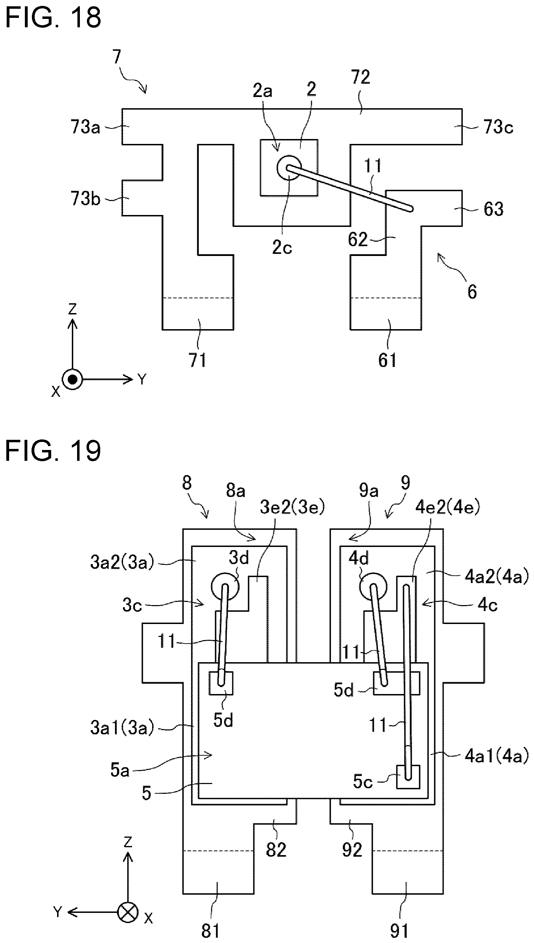

FIG. 16 is a perspective view of a semiconductor relay according to Exemplary Embodiment 2. FIG. 17 is a side view of the semiconductor relay according to Embodiment 2 when viewed in direction D shown in FIG. 16. FIG. 18 is a diagram of a first input terminal and a second input terminal with a light-emitting device placed thereon, when viewed in direction E shown in FIG. 17. FIG. 19 is a diagram of a first output terminal and a second output terminal with a light-receiving driver device, a first MOSFET, and a second MOSFET placed thereon, when viewed in direction F shown in FIG. 17.

In FIG. 16 and the figures described below, elements substantially the same as those of Embodiment 1 are denoted by the same reference numerals, and detailed description thereof will be omitted.

Semiconductor relay 30 according to the present embodiment is different from semiconductor relay 1 according to Embodiment 1 in the following respects.

As illustrated in FIGS. 16-19, first placement part 3a1 of first MOSFET 3 is disposed below first gate electrode 3d in the Z-axis direction. Similarly, second placement part 4a1 of second MOSFET 4 is disposed below second gate electrode 4d in the Z-axis direction.

In contrast, in semiconductor relay 1 according to Embodiment 1, first placement part 3a1 of first MOSFET 3 is disposed above first gate electrode 3d in the Z-axis direction, as illustrated in FIGS. 1-4C. Similarly, second placement part 4a1 of second MOSFET 4 is disposed above second gate electrode 4d in the Z-axis direction.

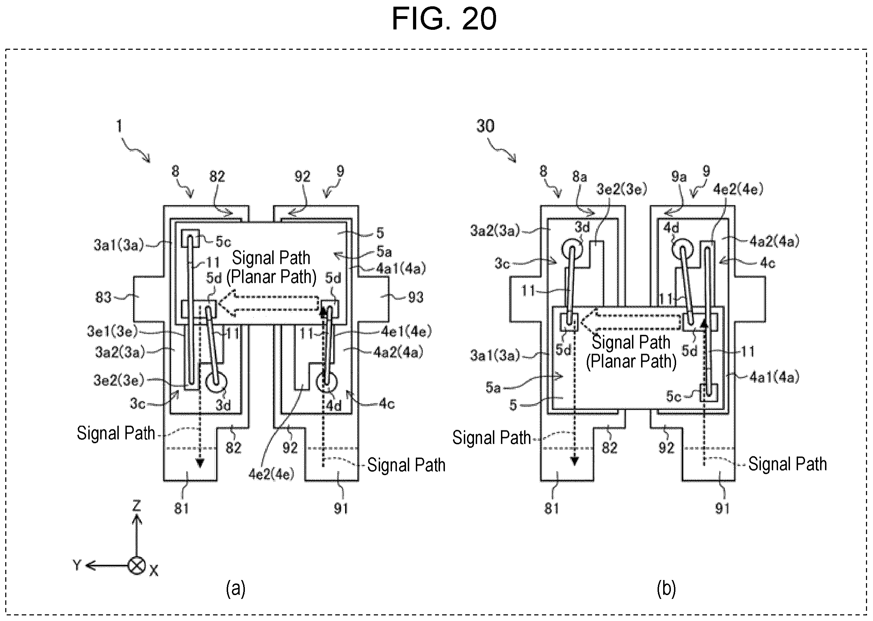

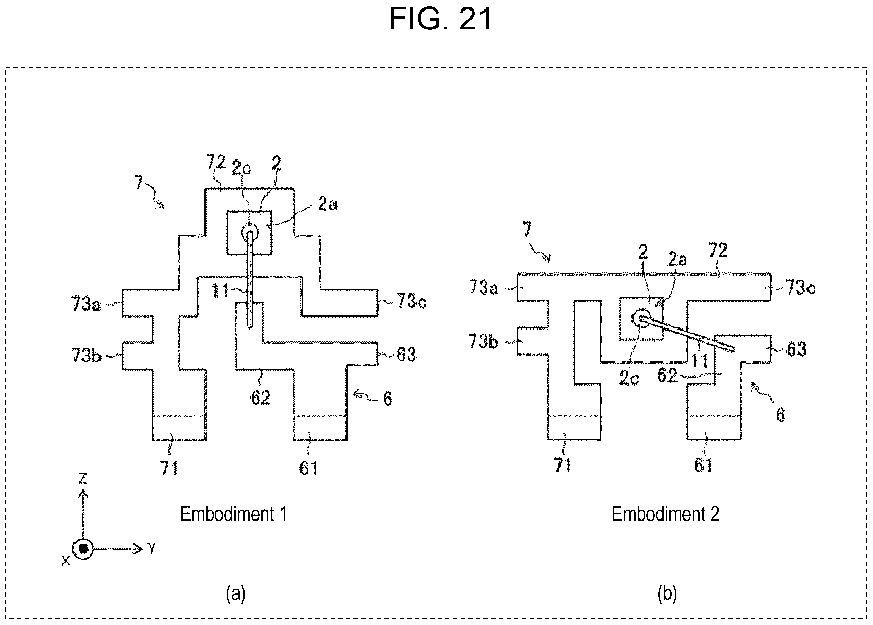

FIG. 20 is a schematic diagram of the relays illustrating a comparison between an output-end signal path according to Embodiment 1 and an output-end signal path according to Embodiment 2. FIG. 21 is a diagram of the relays illustrating positional relationship comparison between the first input terminal, the second input terminal, and the light-emitting device according to Embodiment 1 and a first input terminal, a second input terminal, and a light-emitting device according to Embodiment 2.

As illustrated in FIG. 20, in semiconductor relay 30 according to the present embodiment, a signal path passing through connecting conductor 12 provided on rear surface 5b of light-receiving driver device 5 passes through a position closer to first output terminal 8 and second output terminal 9 than in semiconductor relay 1 according to Embodiment 1.

That is, in accordance with the present embodiment, the signal path is shorter and the parasitic inductance components are further reduced as compared to semiconductor relay 1 according to Embodiment 1. As a result, the insertion loss is further reduced. As a result of reducing of the inductance along the signal path, the characteristic impedance mismatch of the signal path is reduced. Accordingly, as compared to Embodiment 1, the reflective properties in the signal path is improved, and the insertion loss is reduced.

According to the present embodiment, light-receiving driver device 5 is disposed at a position closer to the lower surface of housing 10 that serves as a mounting surface for circuit board 40 than the relay according to Embodiment 1. As a result, light-emitting device mount 72 is disposed at a position closer to the lower surface of housing 10 than Embodiment 1.

As a result, second input terminal 7 including light-emitting device mount 72 has a small height, and accordingly, reducing the height of first input terminal 6. Thus, the areas of portions of first input terminal 6 and second input terminal 7 that face first output terminal 8 and second output terminal 9, respectively, is smaller than those of Embodiment 1.

Increases in the area of portions of first input terminal 6 and second input terminal 7 that face first output terminal 8 and second output terminal 9, respectively, lead to an increase in the capacitive coupling between the input end and the output end and furthermore, lead to an increase in the insertion loss.

According to the present embodiment, the area of portions facing first output terminal 8 and second output terminal 9 is smaller than Embodiment 1, as described above.

As a result, the capacitive coupling between the input end and the output end is reduced, and the insertion loss is reduced. This prevents ripples from being generated at the input end.

As illustrated in FIG. 19, in the present embodiment, branches 73a and 73c out of branches 73a to 73c provided on second input terminal 7 are positioned higher than light-emitting device 2 in the Z-axis direction.

This configuration increases the rigidity of second input terminal 7 in the Z-axis direction.

Second input terminal 7 according to the present embodiment includes light-emitting device mount 72 and an exposed part. Light-emitting device 2 is placed on light-emitting device mount 72. The exposed part is exposed from housing 10 to the outside thereof.

The exposed part includes second input external terminal part 71 and branches 73a to 73c. Second input external terminal part 71 is configured to be connected to circuit board 40. Branches 73a to 73c are configured not to be connected to circuit board 40. Branches 73a and 73c are positioned higher than light-emitting device 2 along the Z-axis direction.

As illustrated in FIG. 17, height H7 of housing 10 from lower surface 10L to the upper end of input terminal 7 is less than height H5 of housing 10 from lower surface 10L to the upper end of light-receiving driver device 5. A small height of input terminal 7 reduces the capacitive coupling between input terminal 7 and light-receiving driver device 5, improving high-frequency characteristics.

Modification 1

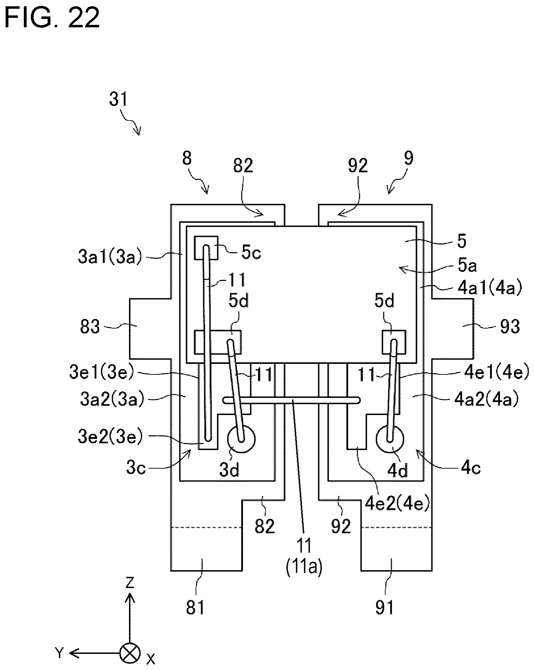

FIG. 22 is a diagram of a first output terminal and a second output terminal with a light-receiving driver device, a first MOSFET, and a second MOSFET placed thereon according to Modification 1 corresponding to FIG. 4A.

As illustrated in FIG. 22, semiconductor relay 31 according to the modification is different from semiconductor relay 1 according to Embodiment 1 in that one wire 11 that connects first source electrode 3e of first MOSFET 3 to second source electrode 4e of second MOSFET 4 is provided.

In semiconductor relay 31 according to this modification, first electrode extension 3e2 of first source electrode 3e is connected to second electrode extension 4e2 of second source electrode 4e with single wire 11, third connector 11a. As described above, first electrode extension 3e2 of first source electrode 3e is formed on first non-placement part 3a2 of first MOSFET 3, and second electrode extension 4e2 of second source electrode 4e is formed on second non-placement part 4a2 of second MOSFET 4. Third connector 11a overlaps none of light-receiving driver device 5 and connecting conductor 12 when viewed in the X-axis direction.

According to the present modification, instead of connecting conductor 12, wire 11 that connects first electrode extension 3e2 to second electrode extension 4e2 is provided on first output external terminal part 81 of first output terminal 8 and second output external terminal part 91 of second output terminal 9. That is, wire 11 provided at a position allowing the signal path to be shortened reduces the inductance along the signal path. Thus, the insertion loss is reduced as compared to the case described in Embodiment 1.

Modification 2

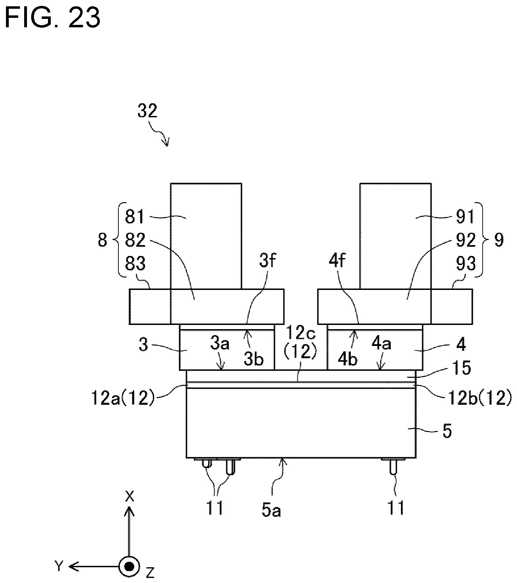

FIG. 23 is a diagram of a first output terminal and a second output terminal with a light-receiving driver device, a first MOSFET, and a second MOSFET placed thereon according to Modification 2 corresponding to FIG. 4B.

Semiconductor relay 32 according to the present modification is different from semiconductor relay 1 according to Embodiment 1 in that third connector 15 is included as a connector that connects connecting conductor 12 to each of first source electrode 3e of first MOSFET 3 and second source electrode 4e of second MOSFET 4.

As illustrated in FIG. 23, third connector 15 which is a laminated electrically conductive sheet formed on the front surface of connecting conductor 12 electrically connects first connector 13 to second connector 14 together with connecting conductor 12. The widths of third connector 15 in the Y-axis direction and the Z-axis direction are substantially equal to the widths of connecting conductor 12 in the Y-axis direction and the Z-axis direction, respectively.

According to the present modification, third connector 15, an electrical conductor, is provided in parallel with connecting conductor 12 and electrically connects first source electrode 3e of first MOSFET 3 to second source electrode 4e of second MOSFET 4 via first connector 13 and second connector 14. This configuration reduces the inductance along the signal path and the insertion loss.

Since third connector 15 is laminated or has a sheet shape, the connection distance from light-receiving driver device 5 to first MOSFET 3 and second MOSFET 4 is prevented from increasing. Thus, the inductance along the signal path is reduced, and the insertion loss is reduced.

In the present modification, third connector 15 is an electrically conductive die attach film, that is, a semiconductor adhesive film mixed with an electrically conductive filler, but this is not limited. For example, third connector 15 may be a metal film. When third connector 15 is an electrically conductive die attach film, there is no need to additionally provide an adhesive material or the like in connecting to each of first connector 13, second connector 14, and connecting conductor 12. Third connector 15 serves as a buffer in mounting light-receiving driver device 5 on first MOSFET 3 and second MOSFET 4, reducing the impact of the pressure that is applied to first MOSFET 3 and second MOSFET 4 during mounting.

Exemplary Embodiment 3

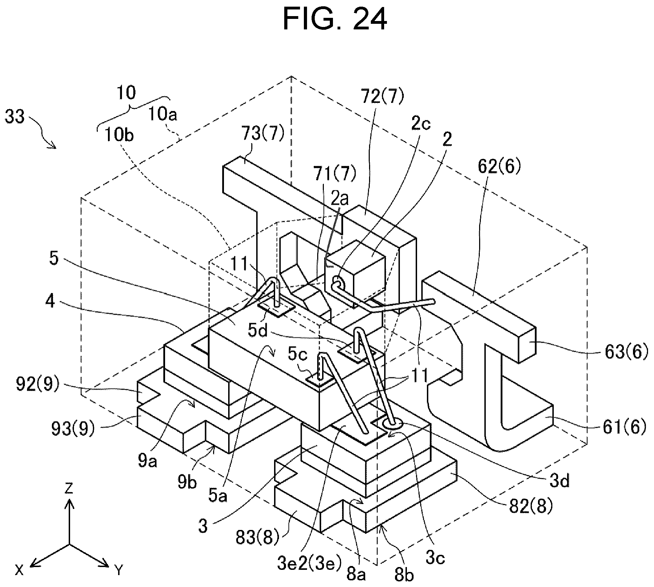

FIG. 24 is a perspective view of a semiconductor relay according to Exemplary Embodiment 3. Semiconductor relay 33 according to Embodiment 3 illustrated in FIG. 24 is different from semiconductor relay 1 according to Embodiment 1 in the following respects.

In first output terminal 8 and second output terminal 9, the directions of the normal lines of front surface 8a of first MOSFET mount 82 and front surface 9a of second MOSFET mount 92 extend in the Z-axis direction. Light-receiving driver device 5, first MOSFET 3, and second MOSFET 4 are stacked in the Z-axis direction. The direction of the normal line of front surface 5a, which is a light-receiving surface of light-receiving driver device 5, is the Z-axis direction.

In semiconductor relay 1 according to Embodiment 1, light-receiving driver device 5, first MOSFET 3, and second MOSFET 4 are stacked in the X-axis direction. The direction of the normal line of front surface 5a, which is a light-receiving surface of light-receiving driver device 5, is also the X-axis direction. The semiconductor relay according to Embodiment 3 is different from Embodiment 1 in that the direction of the normal line of front surface 5a, which is a light-receiving surface of the light-receiving device, is the Z-axis direction while the light-emitting surface of the light-emitting device is the X-axis direction, meaning that these do not face each other.

Rear surfaces 8b and 9b of first MOSFET mount 82 and second MOSFEET mount 92 that are the lower surfaces thereof in the Z-axis direction in this case are exposed on the rear surface of housing 10 and serve as a mounting surface for circuit board 40. In other words, rear surfaces 8b and 9b of first MOSFET mount 82 and second MOSFEET mount 92 correspond to first output external terminal part 81 and second output external terminal part 91 illustrated in FIGS. 1-4C.

In second input terminal 7, one branch 73 protrudes from a side surface of light-emitting device mount 72 in the Y-axis direction. Branch 73 is positioned higher than light-emitting device 2 in the Z-axis direction.

As shown in FIG. 24, first electrode main body 3e1 and second electrode main body 4e1 include portions that overlap light-receiving driver device 5 when viewed in the Z-axis direction.

The present embodiment provides advantageous effects that are substantially the same as those produced by the configuration of Embodiment 1. Specifically, the parasitic inductance components are reduced, and as a result, the insertion loss is reduced. As a result of reducing of the inductance along the signal path, the characteristic impedance mismatch of the signal path is reduced. Accordingly, the reflective properties in the signal path are improved, and furthermore, the insertion loss is reduced. The deterioration of the high-frequency characteristics of transmission signals is reduced, and the impedance mismatch in the signal transmission path is reduced.

Wire 11 connecting source electrode 5c of light-receiving driver device 3 to first source electrode 3e of first MOSFET 3, that is, a member serving as a stub, is shortened. As a result, the characteristic impedance of the signal path is reduced, and therefore, the signal reflective properties in the signal path are improved, and furthermore, the insertion loss is reduced. Moreover, both the inductance components at output terminals 8 and 9 and the capacitive components resulting from input terminals 6 and 7 and output terminals 8 and 9 facing each other are reduced, and thus, the insertion loss is further reduced.

OTHER EMBODIMENT

The structural elements described of Embodiments 1-3 and Modifications 1-3 may be combined, as appropriate, as a new exemplary embodiment. For example, third connector 15 described in Modification 2 may be applied to semiconductor relay 30 described in Embodiment 2 or semiconductor relay 33 described in Embodiment 3. First MOSFET 3 and second MOSFET 4 described in Modification 3 may be applied to semiconductor relays 1, 30, and 33 described in Embodiments 1. This example will be described below.

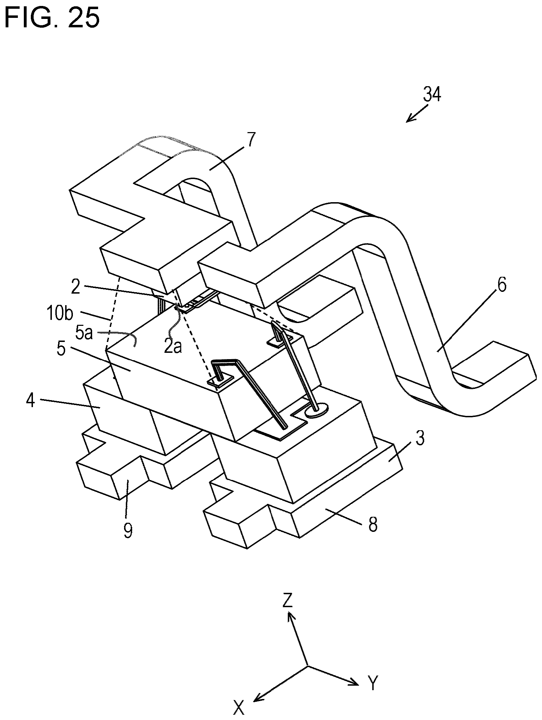

FIG. 25 is a perspective view of another semiconductor relay 34 according to Embodiment 3. In FIG. 25, parts identical to those of semiconductor relay 33 according to Embodiment 3 illustrated in FIG. 24 are denoted by the same reference numerals. In FIG. 25, the illustration of light-blocking resin 10a of housing 10 is omitted to facilitate the understanding of the configuration of main parts. In semiconductor relay 34, front surface 2a of light-emitting device 2 on which anode electrode 2c thereof is provided and that emits light faces, in the Z-axis direction, front surface 5a of light-receiving driver device 5 that receives the light.

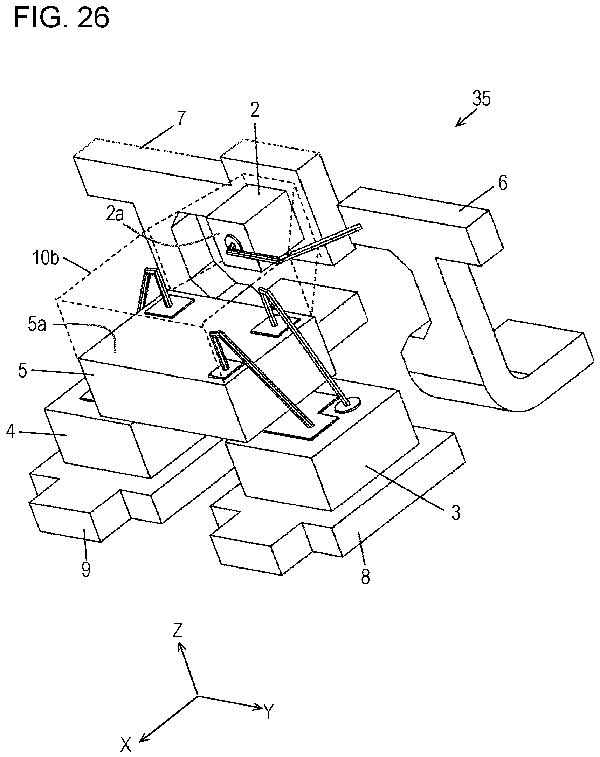

FIG. 26 is a perspective view of still another semiconductor relay 35 according to Embodiment 3. In FIG. 26, components identical to those of semiconductor relay 34 illustrated in FIG. 25 are denoted by the same reference numerals. In FIG. 26, the illustration of light-blocking resin 10a of housing 10 is omitted to facilitate the understanding of the configuration of main parts. In semiconductor relay 35, front surface 2a of light-emitting device 2 on which anode electrode 2c thereof is provided and that emits light is directed in the X-axis direction. Front surface 5a of light-receiving driver device 5 that receives the light is directed in the Z-axis direction perpendicular to the X-axis direction. Thus, front surface 2a of light-emitting device 2 is perpendicular to front surface 5a of light-receiving driver device 5. The light emitted from front surface 2a of light-emitting device 2 is guided by light-transmissive resin 10b and received on front surface 5a of light-receiving driver device 5.

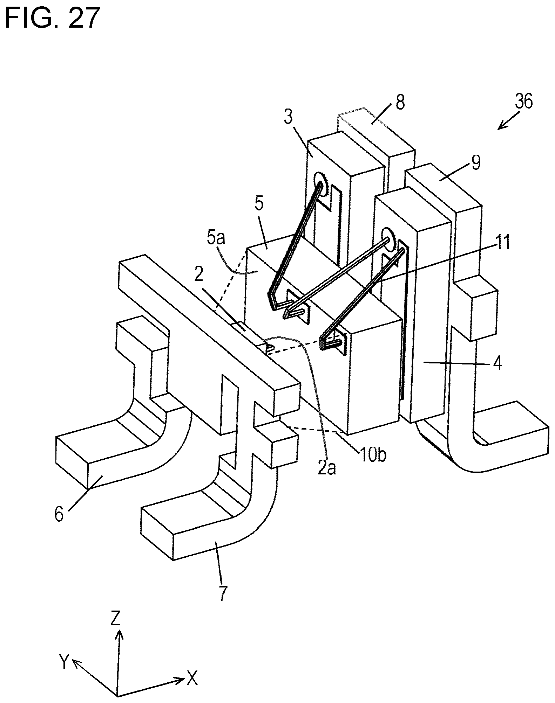

FIG. 27 is a perspective view of another semiconductor relay 36 according to Embodiment 2. In FIG. 27, components identical to those of semiconductor relay 30 according to Embodiment 2 illustrated in FIG. 16 are denoted by the same reference numerals. In FIG. 27, the illustration of light-blocking resin 10a of housing 10 is omitted to facilitate the understanding of the configuration of main parts. In semiconductor relay 36, a terminal of light-receiving driver device 5 that is connected to the source electrode of second MOSFET 4 is located at an upper end part of front surface 5a and is connected to the source electrode of second MOSFET 4 of wire 11. This configuration shortens wire 11 connecting light-receiving driver device 5 to the source electrode of MOSFET 4, and shifts the frequency of resonance generated by a stub toward the high frequency side.

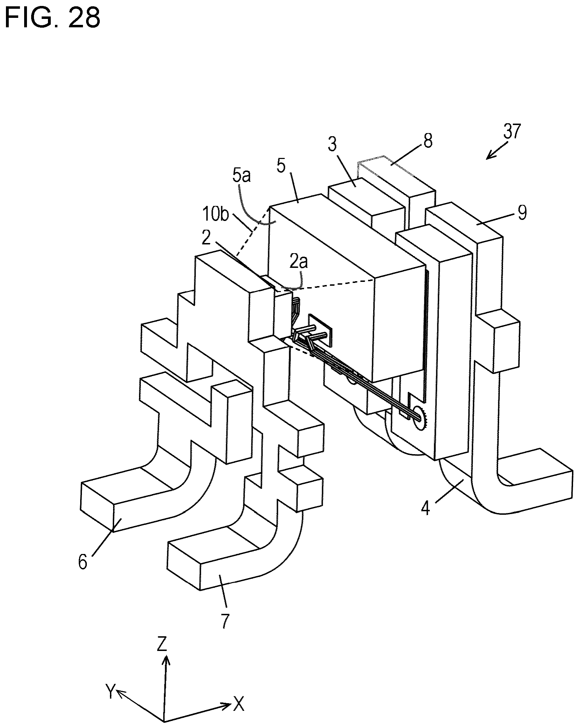

FIG. 28 is a perspective view of still another semiconductor relay 37 according to Embodiment 1. In FIG. 28, components identical to those of semiconductor relay 1 according to Embodiment 1 illustrated in FIG. 1 are denoted by same reference numerals. In FIG. 28, the illustration of light-blocking resin 10a of housing 10 is omitted to facilitate the understanding of the configuration of main parts. In semiconductor relay 37, a terminal of light-receiving driver device 5 that is connected to the source electrode of second MOSFET 4 is located at a lower end part of front surface 5a and is connected to the source electrode of second MOSFET 4 of wire 11.

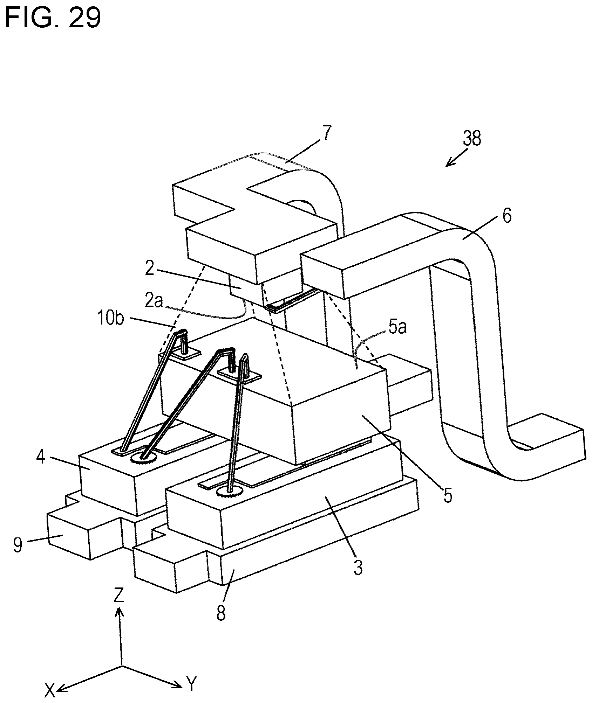

FIG. 29 is a perspective view of further semiconductor relay 38 according to Embodiment 3. In FIG. 29, components identical to those of semiconductor relay 34 illustrated in FIG. 25 are denoted by the same reference numerals. In FIG. 29, the illustration of light-blocking resin 10a of housing 10 is omitted to facilitate the understanding of the configuration of main parts. In semiconductor relay 38, front surface 2a of light-emitting device 2 on which anode electrode 2c thereof is provided and that emits light faces, in the Z-axis direction, front surface 5a of light-receiving driver device 5 that receives the light. Output terminals 8 and 9 and MOSFETs 3 and 4 extending in the X-axis direction. This configuration shortens wire 11 connecting light-receiving driver device 5 to the source electrode of MOSFET 4, and shifts the frequency of resonance generated by a stub toward the high frequency side.

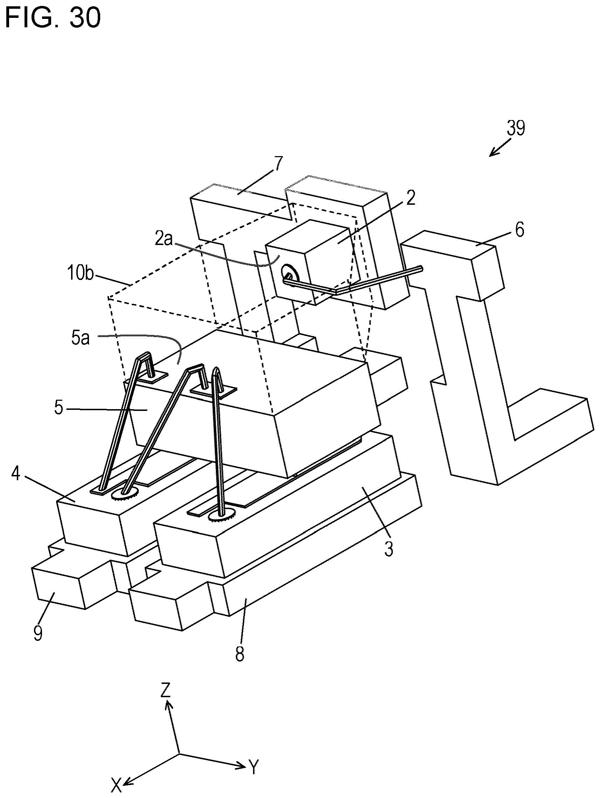

FIG. 30 is a perspective view of further semiconductor relay 39 according to Embodiment 3. In FIG. 30, components identical to those of semiconductor relay 35 illustrated in FIG. 26 are denoted by the same reference numerals. In FIG. 30, the illustration of light-blocking resin 10a of housing 10 is omitted to facilitate the understanding of the configuration of main parts. In semiconductor relay 39, front surface 2a of light-emitting device 2 on which anode electrode 2c thereof is provided and that emits light is directed in the X-axis direction. Front surface 5a of light-receiving driver device 5 that receives the light is directed in the Z-axis direction perpendicular to the X-axis direction. That is, front surface 2a of light-emitting device 2 is perpendicular to front surface 5a of light-receiving driver device 5. The light emitted from front surface 2a of light-emitting device 2 is guided by light-transmissive resin 10b and received on front surface 5a of light-receiving driver device 5. Output terminals 8 and 9 and MOSFETs 3 and 4 extend in the X-axis direction. This configuration in accordance with the present embodiment provides advantageous effects that are substantially the same as those produced by the configuration according to Embodiment 1. Specifically, the parasitic inductance components are reduced, and as a result, the insertion loss is reduced. As a result of reducing of the inductance along the signal path, the characteristic impedance mismatch of the signal path is reduced. Accordingly, the reflective properties in the signal path are improved, and the insertion loss is reduced. Furthermore, the deterioration of the high-frequency characteristics of transmission signals is reduced, and the impedance mismatch in the signal transmission path may be reduced. Moreover, wire 11 connecting the source electrode of light-receiving driver device 5 to the first source electrode of first MOSFET 3, that is, a member serving as a stub, is shortened. As a result, the characteristic impedance of the signal path is reduced, and therefore, the signal reflective properties in the signal path are improved, and the insertion loss is reduced. Both the inductance components at output terminals 8 and 9 and capacitive components resulting from input terminals 6 and 7 and output terminals 8 and 9 facing each other are reduced, thus reducing the insertion loss. In addition, this configuration shortens wire 11 connecting light-receiving driver device 5 to the source electrode of MOSFET 4, and shifts the frequency of resonance generated by a stub toward the high frequency side.

In view of Embodiments 1 to 3, each of first electrode main body 3e1 of first MOSFET 3 and second electrode main body 4e1 of second MOSFET 4 includes a portion that overlaps light-receiving driver device 5 when viewed in the normal line of front surface 5a of light-receiving driver device 5.

Exemplary Embodiment 4

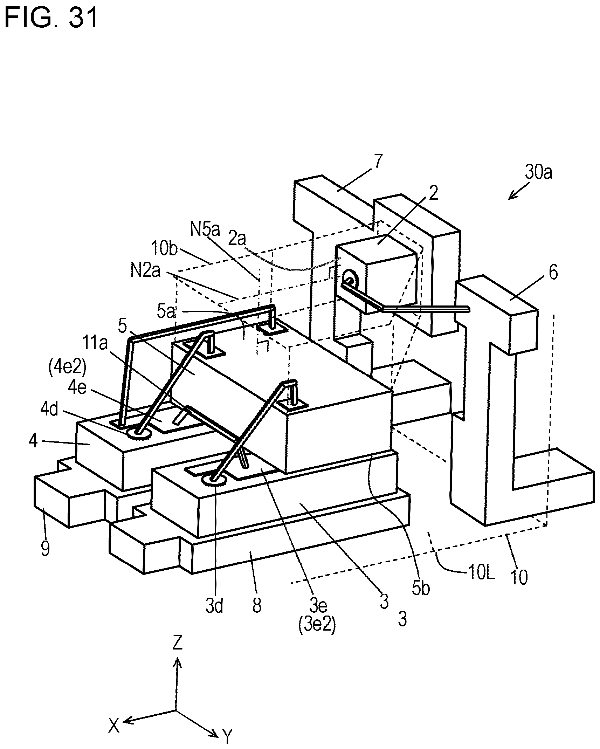

FIG. 31 is a perspective view of semiconductor relay 30a according to Exemplary Embodiment 4. In FIG. 31, components identical to those of the semiconductor relays according to Embodiments 1-3 illustrated in FIGS. 1 to 30 are denoted by the same reference numerals.

Semiconductor relay 30a includes, first input terminal 6, second input terminal 7, light-emitting device 2 electrically connected to first input terminal 6 and second input terminal 7 and having front surface 2a configured to emit light, light-receiving driver device 5 having front surface 5a configured to receive light output from front surface 2a of light-emitting device 2 and rear surface 5b opposite to front surface 5a, first MOSFET 3 having first front surface 3a on which first gate electrode 3d electrically connected to light-receiving driver device 5 is provided, second MOSFET 4 having second front surface 4a on which second gate electrode 4d electrically connected to light-receiving driver device 5 is provided, first output terminal 8 electrically connected to first MOSFET 3, and second output terminal 9 electrically connected to second MOSFET 4. Light-receiving driver device 5 overlaps first MOSFET 3 in plan view. Light-receiving driver device 5 overlaps second MOSFET 4 in plan view. Normal line N2a of front surface 2a of light-emitting device 2 intersects normal line N5a of front surface 5a of light-receiving driver device 5. Normal line N2a of front surface 2a of light-emitting device 2 is not parallel to, in the exemplary embodiment, is perpendicular to normal line N5a of front surface 5a of light-receiving driver device 5.

No connecting conductor is provided on rear surface 5b of light-receiving driver device 5. Specifically, in semiconductor relay 30a, first electrode extension 3e2 of first source electrode 3e is connected to second electrode extension 4e2 of second source electrode 4e with third connector 11a which is one wire 11.

Front surface 5a of light-receiving driver device 5 is parallel to lower surface 10L of housing 10.

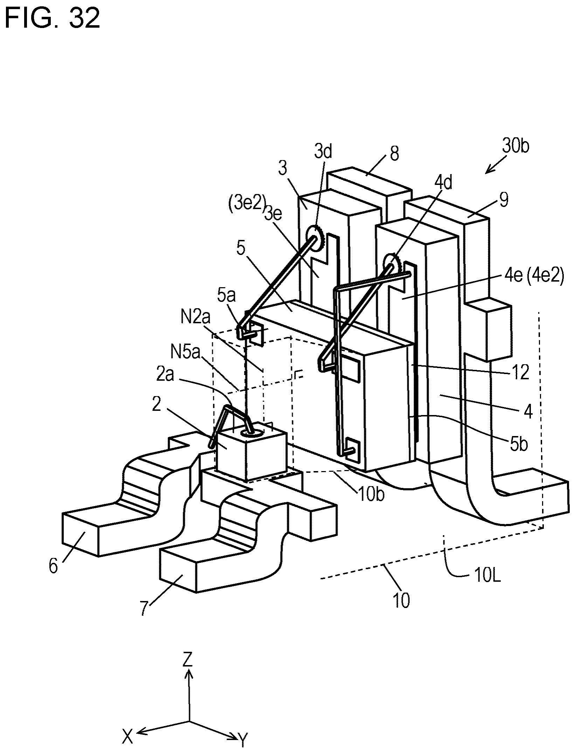

FIG. 32 is a perspective view of another semiconductor relay 30b according to Embodiment 4. In FIG. 32, in FIG. 31, components identical to those of the semiconductor relays illustrated in FIGS. 1-31 are denoted by the same reference numerals.

Connecting conductor 12 is provided on rear surface 5b of light-receiving driver device 5. Specifically, in semiconductor relay 30b, first electrode extension 3e2 of first source electrode 3e is connected to second electrode extension 4e2 of second source electrode 4e with connecting conductor 12.

Front surface 2a of light-emitting device 2 is parallel to lower surface 10L of housing 10.

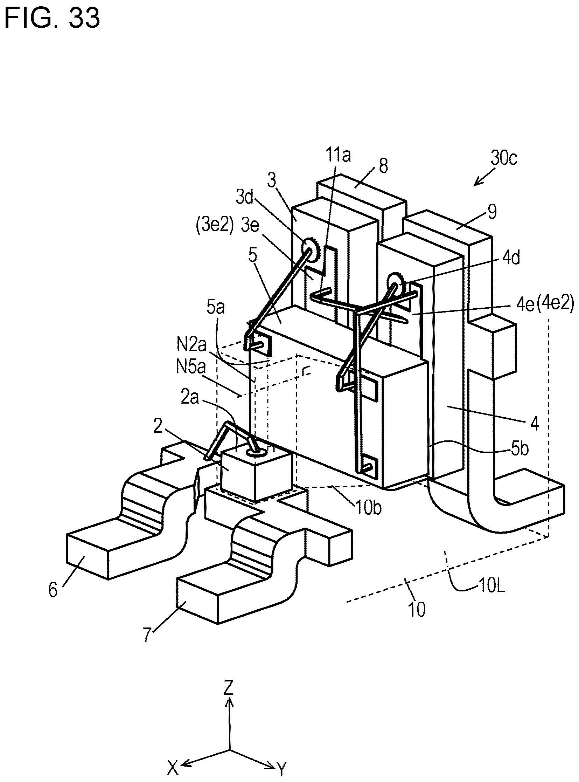

FIG. 33 is a perspective view of still another semiconductor relay 30c according to Embodiment 4. In FIG. 33, components identical to those of the semiconductor relay illustrated in FIG. 32 are denoted by the same reference numerals.

No connecting conductor is provided on rear surface 5b of light-receiving driver device 5. Specifically, in semiconductor relay 30c, first electrode extension 3e2 of first source electrode 3e is connected to second electrode extension 4e2 of second source electrode 4e with third connector 11a which is single wire 11.

Front surface 5a of light-receiving driver device 5 is parallel to lower surface 10L of housing 10.

Semiconductor relays 30a to 30c according to Embodiment 4 reduces the capacitive coupling between the input end and the output end, and reduces the insertion loss. In semiconductor relays 30a to 30c, input terminal 6 and input terminal 7 are shorter than those in the semiconductor relay according to Embodiment 2, thereby suppressing ripples at the input end.

As described above, semiconductor relay 1 according to an aspect of the present disclosure includes:

first input terminal 6; second input terminal 7; light-emitting device 2 electrically connected to first input terminal 6 and second input terminal 7; light-receiving driver device 5 including light-receiving device 51 configured to receive light output from light-emitting device 2, the light-receiving driver device being configured to output a drive signal according to the received light; first output terminal 8; second output terminal 9; first MOSFET 3 including first gate electrode 3d configured to have the drive signal input thereto, first source electrode 3e electrically connected to the light-receiving driver device, and first drain electrode 3f electrically connected to first output terminal 8; second MOSFET 4 including second gate electrode 4d configured to have the drive signal input thereto, second source electrode 4e electrically connected to the light-receiving driver device, and second drain electrode 4f electrically connected to second output terminal 9; and connecting conductor 12 electrically connected to first source electrode 3e and second source electrode 4e. First MOSFET 3 has: first front surface 3a on which first gate electrode 3d and first source electrode 3e are provided; and first rear surface 3b opposite to first front surface 3a. Second MOSFET 4 has: second front surface 4a on which second gate electrode 4d and second source electrode 4e are provided; and second rear surface 4b opposite to second front surface 4a. First front surface 3a of first MOSFET 3 includes: first placement part 3a1 on which first source electrode 3e is provided and light-receiving driver device 5 is placed; and first non-placement part 3a2 on which first gate electrode 3d is provided and light-receiving driver device 5 is not placed. Second front surface 4a of second MOSFET 4 includes: second placement part 4a1 on which second source electrode 4e is provided and light-receiving driver device 5 is placed; and second non-placement part 4a2 on which second gate electrode 4d is provided and light-receiving driver device 5 is not placed. First MOSFET 3 and second MOSFET 4 are located in a first direction (X-axis direction) from light-receiving driver device 5 so as to face rear surface 5b of light-receiving driver device 5. First MOSFET 3 is located in a second direction (Y-axis direction) perpendicular to the first direction (X-axis direction) from second MOSFET 4. Connecting conductor 12 includes: first connecting conductive part 12a that overlaps first MOSFET 3 when viewed in the first direction (X-axis direction); second connecting conductive part 12b that overlaps second MOSFET 4 when viewed in the first direction (X-axis direction); and third connecting conductive part 12c that electrically connects first connecting conductive part 12a to second connecting conductive part 12b and overlaps none of first MOSFET 3 and second MOSFET 4 when viewed in the first direction (X-axis direction). Connecting conductor 12 is provided on rear surface 5b of light-receiving driver device 5.

Connecting conductor 12 may be provided on entire rear surface 5b of light-receiving driver device 5.

Light-receiving driver device 5 may include insulating adhesive sheet 55 provided on rear surface 5b of light-receiving driver device 5. Insulating adhesive sheet 55 allows connecting conductor 12 to adhere to rear surface 5b of light-receiving driver device 5.

The semiconductor relay may further include: first connector 13 provided on the front surface of first source electrode 3e; and second connector 14 provided on the front surface of second source electrode 4e. In this case, first connector 13 electrically connects first source electrode 3e to first connecting conductive part 12a of connecting conductor 12. Second connector 14 electrically connects second source electrode 4e to second connecting conductive part 12b of connecting conductor 12.

First connector 13 and second connector 14 may be arranged in the second direction (Y-axis direction). In this case, the width of connecting conductor 12 in the second direction (Y-axis direction) is greater than or equal to the distance between first connector 13 and second connector 14 in the second direction (Y-axis direction).

First MOSFET 3 may include a first MOSFET functional cell (first cell region 3c). Second MOSFET 4 may include a second MOSFET functional cell. In these cases, first connector 13 does not overlap the first MOSFET functional cell (first cell region 3c) when viewed in the first direction (X-axis direction). Second connector 14 does not overlap the second MOSFET functional cell (second cell region 4c) when viewed in the first direction (X-axis direction).

The semiconductor relay may further include third connector 11a that is connected to first source electrode 3e and second source electrode 4e and overlaps none of light-receiving driver device 5 and connecting conductor 12 when viewed in the first direction (X-axis direction).

The semiconductor relay may further include housing 10 accommodating therein first input terminal 6, second input terminal 7, light-emitting device 2, light-receiving driver device 5, first output terminal 8, second output terminal 9, first MOSFET 3, second MOSFET 4, and connecting conductor 12. In this case, the first direction (X-axis direction), the second direction (Y-axis direction), and the up-down direction (Z-axis direction) are perpendicular to one another. First input terminal 6 includes first input external terminal part 61 that is exposed to the outside of housing 10 along the lower surface of housing 10. Second input terminal 7 includes second input external terminal part 71 that is exposed to the outside of housing 10 along the lower surface of housing 10. First output terminal 8 includes: first output external terminal part 81 that is exposed to the outside of housing 10 along the lower surface of housing 10; and first MOSFET mount 82 on which first MOSFET 3 is placed. Second output terminal 9 includes: second output external terminal part 91 that is exposed to the outside of housing 10 along the lower surface of housing 10; and second MOSFET mount 92 on which second MOSFET 4 is placed. First input external terminal part 61, second input external terminal part 71, first output external terminal part 81, and second output external terminal part 91 are located lower than light-receiving driver device 5.

First placement part 3a1 of first surface 3a of first MOSFET 3 may be located higher than first gate electrode 3d, and second placement part 4a1 of second surface 4a of second MOSFET 4 may be located higher than second gate electrode 4d.

First placement part 3a1 of first surface 3a of first MOSFET 3 may be located lower than first gate electrode 3d. Second placement part 4a1 of second surface 4a of second MOSFET 4 may be located lower than second gate electrode 4d.

Second input terminal 7 may further include: light-emitting device mount 72 on which light-emitting device 2 is placed; and branch 73 exposed from housing 10 to the outside thereof and located higher than second input external terminal part 71. In this case, branch 73 is exposed from housing 10 in a direction different from the first direction (X-axis direction).

Light-emitting device 2 may face light-receiving driver device 5 with a distance in between in the first direction (X-axis direction). In this case, light-receiving driver device 5 is positioned between light-emitting device 2 and first MOSFET 3 and positioned between the light-emitting device and the second MOSFET.

Industrial Applicability

A semiconductor relay according to the present disclosure has a small size and a small insertion loss, and is useful as a device that allows passage and interruption of high-frequency signals.

Reference Signs

1, 20, 30-33 semiconductor relay
2 light-emitting device
3 first metal-oxide-semiconductor field effect transistor (MOSFET) device
3a first front surface
3a1 first placement part
3a2 first non-placement part
3b first rear surface
3c first cell region
3d first gate electrode
3e first source electrode
3e1 first electrode main body
3e2 first electrode extension
3f first drain electrode
4 second MOSFET
4a second front surface
4a1 second placement part
4a2 second non-placement part
4b second rear surface
4c second cell region

4d second gate electrode
4e second source electrode
4e1 second electrode main body
4e2 second electrode extension
4f second drain electrode
5 light-receiving driver device
5a front surface
5b rear surface
51 light-receiving device
52 drive circuit
6 first input terminal
61 first input external terminal part (exposed part)
62 wire connecting part
63 branch (exposed part)
7 second input terminal
71 second input external terminal part (exposed part)
72 light-emitting device mount
73 branch (exposed part)
73a-73c branch (exposed part)
8 first output terminal
81 first output external terminal part (exposed part)
82 first MOSFET mount
83 branch (exposed part)
9 second output terminal
91 second output external terminal part (exposed part)
92 second MOSFET mount
93 branch (exposed part)
10 housing
10a light-blocking resin
10b light-transmissive resin
11 wire
11a wire (third connector)
12 connecting conductor
12a first connecting conductive part
12b second connecting conductive part
12c third connecting conductive part
13 first connector
14 second connector
15 third connector
16 third device mount
17 coating layer
40 circuit board
40a dielectric substrate (dielectric layer)
41 first wire (wiring layer)
42 second wire (wiring layer)
43 third wire (ground layer)
44 conductive via
45 ground plane (ground layer)
100 electric component unit
200 nozzle

## Claims

1. A semiconductor relay comprising:

    a first input terminal;

a second input terminal;
a light-emitting device electrically connected to the first input terminal and the second input terminal;
a light-receiving driver device including a light-receiving device configured to receive light output from the light-emitting device, the light-receiving driver device being configured to output a drive signal according to the received light;
a first output terminal;
a second output terminal;
a first metal-oxide-semiconductor field effect transistor (MOSFET) including a first gate electrode configured to have the drive signal input thereto, a first source electrode electrically connected to the light-receiving driver device, and a first drain electrode electrically connected to the first output terminal;
a second MOSFET including a second gate electrode configured to have the drive signal input thereto, a second source electrode electrically connected to the light-receiving driver device, and a second drain electrode electrically connected to the second output terminal; and
a connecting conductor electrically connected to the first source electrode and the second source electrode, wherein
the first MOSFET has a first front surface and a first rear surface opposite to the first front surface, the first front surface having the first gate electrode and the first source electrode provided thereon,
the second MOSFET has a second front surface and a second rear surface opposite to the second front surface, the second front surface having the second gate electrode and the second source electrode provided thereon,
the first front surface of the first MOSFET includes:

    a first placement having the first source electrode provided thereon and having the light-receiving driver device placed thereon; and
    a first non-placement part having the first gate electrode provided thereon and not having the light-receiving driver device placed thereon,

the second front surface of the second MOSFET includes:

    a second placement part having the second source electrode provided thereon and having the light-receiving driver device placed thereon; and
    a second non-placement part having the second gate electrode provided thereon and not having the light-receiving driver device placed thereon,

the first MOSFET and the second MOSFET are located in a first direction from the light-receiving driver device so as to face a rear surface of the light-receiving driver device, the first MOSFET is arranged in a second direction from the second MOSFET, the second direction being perpendicular to the first direction, the connecting conductor includes:

a first connecting conductive part overlapping the first MOSFET when viewed in the first direction; a second connecting conductive part overlapping the second MOSFET when viewed in the first direction; and a third connecting conductive part that electrically connects the first connecting conductive part to the second connecting conductive part and overlaps none of the first MOSFET and the second MOSFET when viewed in the first direction, and

the connecting conductor is provided on the rear surface of the light-receiving driver device.

2. The semiconductor relay according to claim 1, wherein the connecting conductor is provided on an entirety of the rear surface of the light-receiving driver device.

3. The semiconductor relay according to claim 1 or 2, wherein the light-receiving driver device includes an insulating adhesive sheet provided on the rear surface of the light-receiving driver device, the insulating adhesive sheet causing the connecting conductor to adhere to the rear surface of the light-receiving driver device.

4. The semiconductor relay according to any one of claims 1 to 3, further comprising:

a first connector on a surface of the first source electrode; and a second connector on a surface of the second source electrode, wherein the first connector electrically connects the first source electrode to the first connecting conductive part of the connecting conductor, and the second connector electrically connects the second source electrode to the second connecting conductive part of the connecting conductor.

5. The semiconductor relay according to claim 4, wherein

the first connector and the second connector are arranged in the second direction, and a width of the connecting conductor in the second direction is greater than or equal to a distance between the first connector and the second connector in the second direction.

6. The semiconductor relay according to claim 4, wherein

the first MOSFET includes a first MOSFET functional cell, the second MOSFET includes a second MOSFET functional cell, the first connector does not overlap the first MOSFET functional cell when viewed in the first direction, and the second connector does not overlap the second MOSFET functional cell when viewed in the first direction.

7. The semiconductor relay according to any one of claims 1 to 6, further comprising a third connector connected to the first source electrode and the second source electrode, the third connector not overlapping the light-receiving driver device or the connecting conductor when viewed in the first direction.

8. The semiconductor relay according to any one of claims 1 to 7, further comprising

a housing accommodating therein the first input terminal, the second input terminal, the light-emitting device, the light-receiving driver device, the first output terminal, the second output terminal, the first MOSFET, the second MOSFET, and the connecting conductor, wherein the first direction, the second direction, and an up-down direction are perpendicular to one another, the first input terminal includes a first input external terminal part exposed to outside of the housing along a lower surface of the housing, the second input terminal includes a second input external terminal part exposed to outside of the housing along the lower surface of the housing, the first output terminal includes: a first output external terminal part that is exposed to the outside of the housing along the lower surface of the housing; and a first MOSFET mount on which the first MOSFET is placed, the second output terminal includes a second output external terminal part and a second MOSFET mount, the second output external terminal part being exposed to outside of the housing along the lower surface of the housing, the second MOSFET mount having the second MOSFET placed thereon, and

the first input external terminal part, the second input external terminal part, the first output external terminal part, and the second output external terminal part are located lower than the light-receiving driver device.

9. The semiconductor relay according to claim 8, wherein

the first placement part of the first front surface of the first MOSFET is located higher than the first gate electrode, and
the second placement part of the second front surface of the second MOSFET is located higher than the second gate electrode.

10. The semiconductor relay according to claim 8 or 9, wherein

the first placement part of the first front surface of the first MOSFET is located lower than the first gate electrode, and
the second placement part of the second front surface of the second MOSFET is located lower than the second gate electrode.

11. The semiconductor relay according to any one of claims 8 to 10, wherein

the second input terminal further includes:

a light-emitting device mount having the light-emitting device placed thereon; and
a branch exposed from the housing to outside and located higher than the second input external terminal part, and

the branch is exposed from the housing in a direction different from the first direction.

12. The semiconductor relay according to any one of claims 1 to 11, wherein

the light-emitting device faces the light-receiving driver device face in the first direction with a distance in between, and
the light-receiving driver device is positioned between the light-emitting device and the first MOSFET and between the light-emitting device and the second MOSFET.

13. An electric component unit comprising:

the semiconductor relay according to any one of claims 1 to 12; and
a circuit board having the semiconductor relay mounted thereon, wherein

the circuit board includes a dielectric layer, a wiring layer provided on the dielectric layer, and a ground layer provided on the dielectric layer, and
the wiring layer includes:

two first wires connected to the first input terminal and the second input terminal, respectively; and
two second wires connected to the first output terminal and the second output terminal, respectively.

# FIG. 1

FIG. 2

FIG. 3

# FIG. 4A

FIG. 4B

FIG. 4C

## FIG. 5

## FIG. 6A

## FIG. 6B

FIG. 7

EP 4 682 960 A1

# FIG. 8

FIG. 9

# FIG. 10A

EP 4 682 960 A1

# FIG. 10B

Signal Path

Signal Path

Signal Path
(Planar Path)

## FIG. 10C

FIG. 11

# FIG. 12

(a)

(b)

FIG. 13

# FIG. 14

EP 4 682 960 A1

# FIG. 15

Capacitive Coupling Between Input Side and Ground Potential

(a)

(b)

EP 4 682 960 A1

# FIG. 16

EP 4 682 960 A1

# FIG. 17

FIG. 18

FIG. 19

# FIG. 20

EP 4 682 960 A1

# FIG. 21

(a) Embodiment 1

(b) Embodiment 2

FIG. 22

## FIG. 23

# FIG. 24

## FIG. 25

## FIG. 26

FIG. 27

FIG. 28

FIG. 29

FIG. 30

# FIG. 31

FIG. 32

# FIG. 33

## INTERNATIONAL SEARCH REPORT

| International application No. |
|---|
| **PCT/JP2024/007704** |

### A. CLASSIFICATION OF SUBJECT MATTER

*H01L 31/12*(2006.01)i; *H01L 25/00*(2006.01)i
FI:  H01L31/12 D; H01L25/00 A

According to International Patent Classification (IPC) or to both national classification and IPC

### B. FIELDS SEARCHED

Minimum documentation searched (classification system followed by classification symbols)

H01L31/12; H01L25/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2020-096105 A (KABUSHIKI KAISHA TOSHIBA) 18 June 2020 (2020-06-18) entire text, all drawings | 1-13 |
| A | JP 2015-050281 A (KABUSHIKI KAISHA TOSHIBA) 16 March 2015 (2015-03-16) entire text, all drawings | 1-13 |
| A | JP 2021-125670 A (KABUSHIKI KAISHA TOSHIBA) 30 August 2021 (2021-08-30) entire text, all drawings | 1-13 |
| A | JP 2020-088091 A (KABUSHIKI KAISHA TOSHIBA) 04 June 2020 (2020-06-04) entire text, all drawings | 1-13 |
| A | JP 2011-166077 A (PANASONIC ELECTRIC WORKS CO., LTD.) 25 August 2011 (2011-08-25) entire text, all drawings | 1-13 |

☐ Further documents are listed in the continuation of Box C.        ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **19 March 2024** | **02 April 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/007704**

| Patent document cited in search report | | | Publication date (day/month/year) | Patent family member(s) | | | Publication date (day/month/year) |
|---|---|---|---|---|---|---|---|
| JP | 2020-096105 | A | 18 June 2020 | US | 2020/0194411 | A1 | |
| | | | | CN | 111403542 | A | |
| JP | 2015-050281 | A | 16 March 2015 | US | 2015/0060892 | A1 | |
| JP | 2021-125670 | A | 30 August 2021 | US | 2021/0247567 | A1 | |
| | | | | CN | 113257946 | A | |
| JP | 2020-088091 | A | 04 June 2020 | US | 2020/0161494 | A1 | |
| | | | | CN | 111211198 | A | |
| JP | 2011-166077 | A | 25 August 2011 | US | 2012/0199851 | A1 | |
| | | | | WO | 2011/042796 | A1 | |
| | | | | KR | 10-2012-0081125 | A | |
| | | | | CN | 102656803 | A | |

Form PCT/ISA/210 (patent family annex) (July 2022)

**EP 4 682 960 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5491894 B